# EUROPEAN PATENT APPLICATION

(11) **EP 2 133 380 A1**
(43) Date of publication of application: **16.12.2009**
(21) Application number: 08722764.1
(22) Date of filing: 25.03.2008
(51) Int. Cl.: C08G 59/24, C08G 59/02, C08J 5/24

(54) **RESIN COMPOSITION**

(30) Priority: 26.03.2007 JP 2007078666
(71) Applicant: Sumitomo Chemical Company, Limited, Tokyo 104-8260 (JP)
(72) Inventor: TANAKA, Shinya, Toyono-gun Osaka 563-0103 (JP); TAKEZAWA, Yoshitaka, Ibaraki 3191292 (JP)
(74) Representative: Vossius & Partner
(86) International application number: PCT/JP2008/055554
(87) International publication number: WO 2008/123238

(57) **Abstract**

A resin composition comprising an epoxy compound denoted by the formula (1): 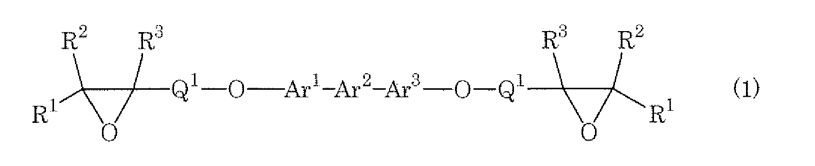 wherein Ar¹, Ar² and Ar³ are the same or different and each denotes any one of divalent groups denoted by the following formulas: 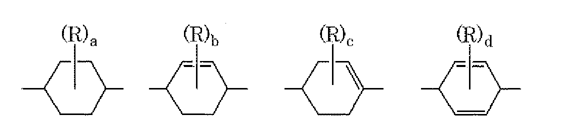 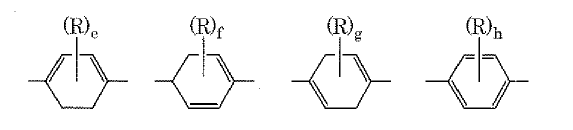 wherein R denotes a hydrogen atom or an alkyl group having 1 to 8 carbon atoms, and an epoxy compound denoted by the formula (2): 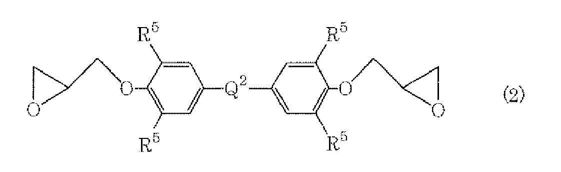 wherein R⁵ denotes a hydrogen atom or an alkyl group having 1 to 8 carbon atoms, and Q² denotes a single bond or a straight-chain alkylene group having 1 to 8 carbon atoms.

## Description

### Technical Field

This application claims priority under the Paris Convention on Japanese Patent Application No. 2007-078666, the disclosure of which is incorporated by reference herein.
The present invention relates to a resin composition.

### Background Art

U.S. Patent No. 5,811,504 and EP 1698625 A1 disclose that a cured resin obtained by curing an epoxy compound having a mesogen group using a curing agent such as a diamine compound exhibits liquid crystallinity.
Patent Document 1: U.S. Patent No. 5,811,504
Patent Document 2: EP 1698625 A1

### Disclosure of the Invention

The present invention provides:
<1> a resin composition comprising an epoxy compound denoted by the formula (1) (Hereinafter it may be abbreviated as an epoxy compound (1).): 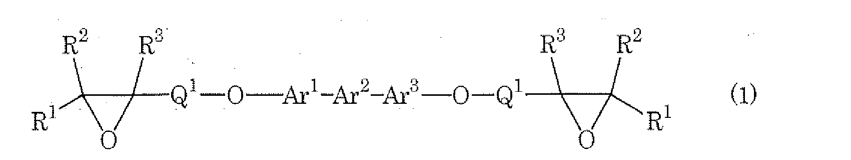 wherein Ar¹, Ar² and Ar³ are the same or different and each denotes any one of divalent groups denoted by the following formulas: 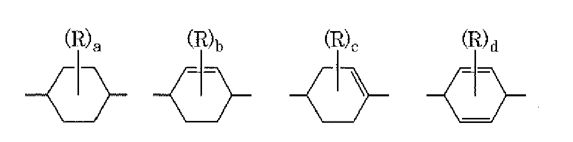 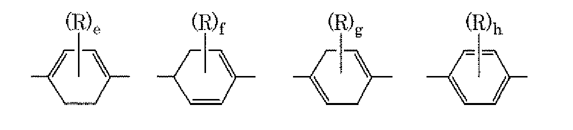 wherein R denotes a hydrogen atom or an alkyl group having 1 to 8 carbon atoms, a denotes an integer of 1 to 8, b, e and g denote an integer of 1 to 6, c denotes an integer of 1 to 7, d and h denote an integer of 1 to 4, f denotes an integer of 1 to 5, and when a to h denote an integer of 2 or more, all of R may be the same group or different groups; R¹, R² and R³ are the same or different and each denotes a hydrogen atom or an alkyl group having 1 to 8 carbon atoms; Q¹ denotes a straight-chain alkylene group having 1 to 8 carbon atoms,
wherein methylene groups composing said straight-chain alkylene group are optionally substituted with an alkyl group having 1 to 8 carbon atoms and -O- or -N(R⁴)- is optionally inserted between the methylene groups, wherein R⁴ denotes a hydrogen atom or an alkyl group having 1 to 8 carbon atoms, and an epoxy compound denoted by the formula (2) (Hereinafter it may be abbreviated as an epoxy compound (2).): 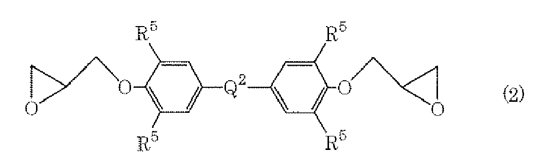 wherein R⁵ denotes a hydrogen atom or an alkyl group having 1 to 8 carbon atoms, Q² denotes a single bond or a straight-chain alkylene group having 1 to 8 carbon atoms, wherein methylene groups composing said straight-chain alkylene group are optionally substituted with an alkyl group having 1 to 8 carbon atoms;

<2> the resin composition according to <1>, wherein a weight ratio of the epoxy compound denoted by the formula (1) to the epoxy compound denoted by the formula (2), (epoxy compound denoted by the formula (1)/epoxy compound denoted by the formula (2)), is from 98/2 to 50/50;

<3> the resin composition according to <1> or <2>, wherein the epoxy compound denoted by the formula (1) is an epoxy compound denoted by the formula (3): 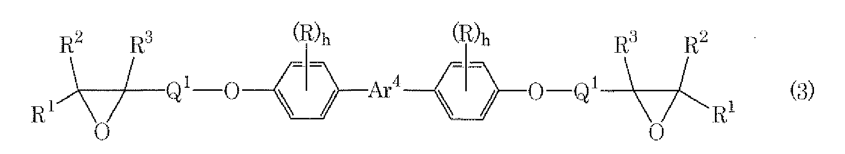 wherein Ar⁴ denotes any one of bivalent groups denoted by the following formulas: 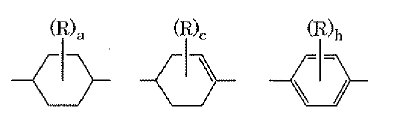 wherein R, R¹, R² , R³, a, c and h are the same as defined above, Q¹ denotes any one of groups denoted by the following formulas: 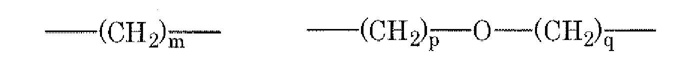 wherein m denotes an integer of 1 to 8, p and q denote an integer of 1 to 7 and the sum of p and q is 8 or less,
wherein methylene groups composing a group denoted by Q¹ are optionally substituted with an alkyl group having 1 to 8 carbon atoms;

<4> the resin composition according to <3>, wherein R¹, R² and R³ are hydrogen atoms;

<5> the resin composition according to any one of <1> to <4>, further containing a curing agent;

<6> the resin composition according to <5>, further containing a filler;

<7> a cured resin obtained by curing the resin composition according to <5> or <6>;

<8> the cured resin according to <7>, wherein the curing temperature is from 120°C to 200°C;

<9> a cured resin obtained by curing the resin composition according to <6>;

<10> the cured resin according to <9>, wherein the curing temperature is from 120°C to 200°C; and

<11> a prepreg obtained by applying or impregnating a base material with the resin composition according to any one of <1> to <6> and semi-curing the applied or impregnated base material.

### Best Mode for Carrying Out the Invention

First, the epoxy compound (1) will be explained.
Examples of the alkyl group having 1 to 8 carbon atoms include a straight-chain or branched-chain alkyl group having 1 to 8 carbon atoms such as methyl, ethyl, n-propyl, isopropyl, n-butyl, isobutyl, sec-butyl, tert-butyl, n-pentyl, tert-amyl, n-hexyl, n-octyl, isooctyl and tert-octyl group.

Examples of the divalent group denoted by the above formulas include cyclohexane-1,4-diyl, 2-cyclohexene-1,4-diyl, 1-cyclohexene-1,4-diyl, 1,4-cyclohexadiene-3,6-diyl, 1,3-cyclohexadiene-1,4-diyl, 1,3-cyclohexanediene-2,5-diyl, 1,4-cyclohexanediene-1,4-diyl, 2-methylcyclohexane-1,4-diyl, 2-methylcyclohexene-1,4-diyl, 1,4-phenylene, 3-methyl-1,4-phenylene, 3-ethyl-1,4-phenylene, 3-n-propyl-1,4-phenylene, 3-isopropyl-1,4-phenylene, 3-n-hutyl-1,4-phenylene, 3-sec-butyl-1,4-phenylene, 3-tert-butyl-1,4-phenylene, 3-n-pentyl-1,4-phenylene, 3-(1-methylbutyl)-1,4-phenylene, 3-(1,1-dimethylpropyl)-1,4-phenylene, 3-n-hexyl-1,4-phenylene, 3-(1-methylpentyl)-1,4-phenylene, 3-(2-methylpentyl)-1,4-phenylene, 3-(1-ethylbutyl)-1,4-phenylene, 3-(2-ethylbutyl)-1,4-phenylene, 3-cyclohexyl-1,4-phenylene, 3-n-heptyl-1,4-phenylene, 3-(1-methylcyclohexyl)-1,4-phenylene, 3-n-octyl-1,4-phenylene, 3-(2-ethylhexyl)-1,4-phenylene, 3,5-dimethyl-1,4-phenylene, 3,5-diethyl-1,4-phenylene, 3,5-di-n-propyl-1,4-phenylene, 3,5-diisopropyl-1,4-phenylene, 3,5-di-n-butyl-1,4-phenylene, 3,5-di-sec-butyl-1,4-phenylene, 3,5-di-tert-butyl-1,4-phenylene and 3,5-di-tert-amyl-1,4-phenylene group.

Examples of the straight-chain alkylene group having 1 to 8 carbon atoms include groups formed by bonding 1 to 8 methylene groups linearly, such as methylene, ethylene, trimethylene, tetramethylene, hexamethylene and octamethylene group. Methylene groups composing the straight-chain alkylene group having 1 to 8 carbon atoms are optionally substituted with an alkyl group having 1 to 8 carbon atoms and -O- or -N(R⁴)- is optionally inserted between the methylene groups, and specific examples thereof include 2-methyltrimethylene, 1,2-dimethylpropylene, 3-oxatetramethylene and 3-oxapentamethylene group.

Among these epoxy compounds (1), preferred is an epoxy compound denoted by the following formula (3): 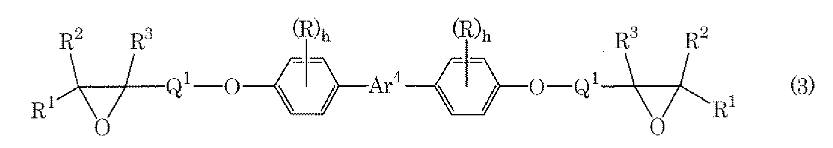 wherein Ar⁴ denotes any one of divalent groups denoted by the following formulas: 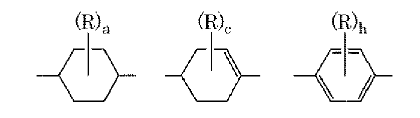 wherein R, R¹, R², R³, a, c and h are the same as defined above; Q¹ denotes any one of groups denoted by the following formulas: 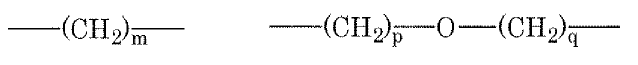 wherein m denotes an integer of 1 to 8; p and q denote an integer of 1 to 7 and the sum of p and q is 8 or less,
wherein methylene groups composing the group denoted by Q¹ are optionally substituted with an alkyl group having 1 to 8 carbon atoms, and particularly preferred is an epoxy compound
wherein R¹, R² and R³ are hydrogen atoms.

Examples of the epoxy compound (1) include:
1,4-bis{4-(oxiranylmethoxy)phenyl}cyclohexane,
1-{2-methyl-4-(oxiranylmethoxy)phenyl}-4-{4-(oxiranylmethoxy)phenyl}cyclohexane,
1-{3-methyl-4-(oxiranylmethoxy)phenyl}-4-{4-(oxiranylmethoxy)phenyl}cyclohexane,
1-{3-ethyl-4-(oxiranylmethoxy)phenyl}-4-{4-(oxiranylmethoxy)phenyl}-cyclohexane,
1-{3-n-propyl-4-(oxiranylmethoxy)phenyl}-4-{4-(oxiranylmethoxy)phenyl}-cyclohexane,
1-{3-isopropyl-4-(oxiranylmethoxy)phenyl}-4-{4-(oxiranylmethoxy)phenyl}-cyclohexane,
1-{3-n-butyl-4-(oxiranylmethoxy)phenyl}-4-{4-(oxiranylmethoxy)phenyl}-cyclohexane,
1-{3-sec-butyl-4-(oxiranylmethoxy)phenyl}-4-{4-(oxiranylmethoxy)phenyl}-cyclohexane,
1-{3-tert-butyl-4-(oxiranylmethoxy)phenyl}-4-{4-(oxiranylmethoxy)phenyl}-cyclohexane,
1-{3-n-pentyl-4-(oxiranylmethoxy)phenyl}-4-{4-(oxiranylmethoxy)phenyl}-cyclohexane,
1-{3-tert-pentyl-4-(oxiranylmethoxy)phenyl}-4-{4-(oxiranylmethoxy)phenyl}-cyclohexane,
1-{3-n-hexyl-4-(oxiranylmethoxy)phenyl}-4-{4-(oxiranylmethoxy)phenyl}-cyclohexane,
1-{3-(1-methylpentyl)-4-(oxiranylmethoxy)phenyl}-4-{4-(oxiranylmethoxy)phenyl}-cyclohexane,
1-{3-(1-ethylbutyl)-4-(oxiranylmethoxy)phenyl}-4-{4-(oxiranylmethoxy)phenyl}-cyclohexane,
1-{3-cyclohexyl-4-(oxiranylmethoxy)phenyl}-4-{4-(oxiranylmethoxy)phenyl}-cyclohexane,
1-{3-n-heptyl-4-(oxiranylmethoxy)phenyl}-4-{4-(oxiranylmethoxy)phenyl}-cyclohexane,
1-{3-n-octyl-4-(oxiranylmethoxy)phenyl}-4-{4-(oxiranylmethoxy)phenyl}-cyclohexane,

1-{3-(2-ethylhexyl)-4-(oxiranylmethoxy)phenyl}-4-{4-(oxiranylmethoxy)phenyl}-cyclohexane,
1-{3-tert-octyl-4-(oxiranylmethoxy)phenyl}-4-{4-(oxiranylmethoxy)phenyl}-cyclohexane,
1-{3-cyclooctyl-4-(oxiranylmethoxy)phenyl}-4-{4-(oxiranylmethoxy)phenyl}-cyclohexane,
1-{3-methyl-4-(2-methyl-oxiranylmethoxy)phenyl}-4-{4-(2-methyl-oxiranylmethoxy)phenyl}-cyclohexane,
1-{3-methyl-4-(3-methyl-oxiranylmethoxy)phenyl}-4-{4-(3-methyl-oxiranylmethoxy)phenyl}-cyclohexane,
1,4-bis{4-(oxiranylmethoxy)phenyl}-1-cyclohexene,
1-{2-methyl-4-(oxirarnylmethoxy)phenyl}-4-{4-(oxiranylmethoxy)phenyl}-1-cyclohexene,
1-{3-methyl-4-(oxiranylmethoxy)phenyl}-4-{4-(oxiranylmethoxy)phenyl}-1-cyclohexene,
1-{3-ethyl-4-(oxiranylmethoxy)phenyl}-4-{4-(oxiranylmethoxy)phenyl}-1-cyclohexene,
1-{3-n-propyl-4-(oxiranylmethoxy)phenyl}-4-{4-(oxiranylmethoxy)phenyl}-1-cyclohexene,
1-{3-isopropyl-4-(oxiranylmethoxy)phenyl}-4-{4-(oxiranylmethoxy)phenyl}-1-cyclohexene,
1-{3-n-butyl-4-(oxiranylmethoxy)phenyl}-4-{4-(oxiranylmethoxy)phenyl}-1-cyclohexene,
1-{3-sec-butyl-4-(oxiranylmethoxy)phenyl}-4-{4-(oxiranylmethoxy)phenyl}-1-cyclohexene,
1-{3-tert-butyl-4-(oxiranylmethoxy)phenyl}-4-{4-(oxiranylmethoxy)phenyl}-1-cyclohexene,
1-{3-n-pentyl-4-(oxiranylmethoxy)phenyl}-4-{4-(oxiranylmethoxy)phenyl}-1-cyclohexene,
1-{3-tert-pentyl-4-(oxiranylmethoxy)phenyl}-4-{4-(oxiranylmethoxy)phenyl}-1-oyclohexene,
1-{3-n-hexyl-4-(oxiranylmethoxy)phenyl}-4-{4-(oxiranylmethoxy)phenyl}-1-cyclohexene,
1-{3-(1-methylpentyl)-4-(oxiranylmethoxy)phenyl}-4-{4-(oxiranylmethoxy)phenyl}-1-cyclohexene,
1-{3-(1-ethylbutyl)-4-(oxiranylmethoxy)phenyl}-4-{4-(oxiranylmethoxy)phenyl}-1-cyclohexene,
1-{3-cyclohexyl-4-(oxiranylmethoxy)phenyl}-4-{4-(oxiranylmethoxy)phenyl}-1-cyclohexene,
1-{3-n-heptyl-4-(oxiranylmethoxy)phenyl}-4-{4-(oxiranylmethoxy)phenyl}-1-cyclohexene,
1-{3-n-octyl-4-(oxiranylmethoxy)phenyl}-4-{4-(oxiranylmethoxy)phenyl}-1-cyolohexene,
1-{3-(2-ethylhexyl)-4-(oxiranylmethoxy)phenyl}-4-{4-(oxiranylmethoxy)phenyl}-1-cyclohexene,
1-{3-tert-octyl-4-(oxiranylmethoxy)phenyl}-4-{4-(oxiranylmethoxy)phenyl}-1-cyclohexene,
1-{3-cyclooctyl-4-(oxiranylmethoxy)phenyl}-4-{4-(oxiranylmethoxy)phenyl}-1-cyclohexene,
1-{3-methyl-4-(2-methyl-oxiranylmethoxy)phenyl}-4-{4-(2-methyl-oxiranylmethoxy)phenyl}-1-cyclohexene,
1-{3-methyl-4-(3-methyl-oxiranylmethoxy)phenyl}-4-{4-(3-methyl-oxiranylmethoxy)phenyl}-1-cyclohexene,
4-bis{4-(oxiranylmethoxy)phenyl}-2-cyclohexene,
1-{2-methyl-4-(oxiranylmethoxy)phenyl}-4-{4-(oxiranylmethoxy)phenyl}-2-cyclohexene,
1-{3-methyl-4-(oxiranylmethoxy)phenyl}-4-{4-(oxiranylmethoxy)phenyl}-2-cyclohexene,
1-{2-methyl-4-(oxiranylmethoxy)phenyl}-4-{4-(oxiranylmethoxy)phenyl}-2-cyclohexene,
1-{3-ethyl-4-(oxiranylmethoxy)phenyl}-4-{4-(oxiranylmethoxy)phenyl}-2-cyclohexene,
1-{3-n-propyl-4-(oxiranylmethoxy)phenyl}-4-{4-(oxiranylmethoxy)phenyl}-2-cyclohexene,
1-{3-isopropyl-4-(oxiranylmethoxy)phenyl}-4-{4-(oxiranylmethoxy)phenyl}-2-cyclohexene,
1-{3-n-butyl-4-(oxiranylmethoxy)phenyl}-4-{4-(oxiranylmethoxy)phenyl}-2-oyclohexene,
1-{3-sec-butyl-4-(oxiranylmethoxy)phenyl}-4-{4-(oxiranylmethoxy)phenyl}-2-cyclohexene,
1-{3-tert-butyl-4-(oxiranylmethoxy)phenyl}-4-{4-(oxiranylmethoxy)phenyl}-2-cyclohexene,
1-{3-n-pentyl-4-(oxiranylmethoxy)phenyl}-4-{4-(oxiranylmethoxy)phenyl}-2-cyclohexene,
1-{3-tert-pentyl-4-(oxiranylmethoxy)phenyl}-4-{4-(oxiranylmethoxy)phenyl}-2-cyclohexene,
1-{3-n-hexyl-4-(oxiranylmethoxy)phenyl}-4-{4-(oxiranylmethoxy)phenyl}-2-cyclohexene,
1-{3-(1-methylpentyl)-4-(oxiranylmethoxy)prenyl}-4-{4-(oxiranylmethoxy)phenyl}-2-cyclohexene,
1-{3-(1-ethylbutyl)-4-(oxiranylmethoxy)phenyl}-4-{4-(oxiranylmethoxy)phenyl}-2-cyclohexene,
1-{3-cyclohexyl-4-(oxiranylmethoxy)phenyl}-4-{4-(oxiranylmethoxy)phenyl}-2-cyclohexene,
1-{3-n-heptyl-4-(oxiranylmethoxy)phenyl}-4-{4-(oxiranylmethoxy)phenyll-2-cyclohexene,
1-{3-n-octyl-4-(oxiranylmethoxy)phenyl}-4-{4-(oxiranylmethoxy)phenyl}-2-cyclohexene,
1-{3-(2-ethylhexyl)-4-(oxiranylmethoxy)phenyl}-4-{4-(oxiranylmethoxy)phenyl}-2-cyclohexene,
1-{3-tert-octyl-4-(oxiranylmethoxy)phenyl}-4-{4-(oxiranylmethoxy)phenyl}-2-cyclohexene,
1-{3-cyclooctyl-4-(oxiranylmethoxy)phenyl}-4-{4-(oxiranylmethoxy)phenyl}-2-cyclohexene,
1-{3-methyl-4-(2-methyl-oxiranylmethoxy)phenyl}-4-{4-(2-methyl-oxiranylmethoxy)phenyl}-2-cyclohexene,
1-{3-methyl-4-(3-methyl-oxiranylmethoxy)phenyl}-4-{4-(3-methyl-oxiranylmethoxy)phenyl}-2-cyclohexene,
1,4-bis{4-(oxiranylmethoxy)phenyl)-2,5-cyclohexadiene,
1-{2-methyl-4-(oxiranylmethoxy)phenyl}-4-{4-(oxiranylmethoxy)phenyl}-2,5-cyclohexadiene,
1-{3-methyl-4-(oxiranylmethoxy)phenyl}-4-{4-(oxiranylmethoxy)phenyl}-2,5-cyclohexadiene,
1-{3-ethyl-4-(oxiranylmethoxy)phenyl}-4-{4-(oxiranylmethoxy)phenyl}-2,5-cyclohexadiene,
1-{3-n-propyl-4-(oxiranylmethoxy)phenyl}-4-{4-(oxiranylmethoxy)phenyl}-2,5-cyclohexadiene,
1-{3-isopropyl-4-(oxiranylmethoxy)phenyl}-4-{4-(oxiranylmethoxy)phenyl}-2,5-cyclohexadiene,
1-{3-n-butyl-4-(oxiranylmethoxy)phenyl}-4-{4-(oxiranylmethoxy)phenyl}-2,5-cyclohexadiene,
1-{3-sec-butyl-4-(oxiranylmethoxy)phenyl}-4-{4-(oxiranylmethoxy)phenyl}-2,5-cyclohexadiene,
1-{3-tert-butyl-4-(oxiranylmethoxy)phenyl}-4-{4-(oxiranylmethoxy)phenyl}-2,5-cyclohexadiene,
1-{3-n-pentyl-4-(oxiranylmethoxy)phenyl}-4-{4-(oxiranylmethoxy)phenyl}-2,5-cyclohexadiene,
1-{3-tert-pentyl-4-(oxiranylmethoxy)phenyl}-4-{4-(oxiranylmethoxy)phenyl}-2,5-cyclohexadiene,
1-{3-n-hexyl-4-(oxiranylmethoxy)phenyl}-4-{4-(oxiranylmethoxy)phenyl}-2,5-cyclohexadiene,
1-{3-(1-methylpentyl)-4-(oxiranylmethoxy)phenyl}-4-{4-(oxiranylmethoxy)phenyl}-2,5-cyclohexadiene,
1-{3-(1-ethylbutyl)-4-(oxiranylmethoxy)phenyl}-4-{4-(oxiranylmethoxy)phenyl}-2,5-cyclohexadiene,
1-{3-cyclohexyl-4-(oxiranylmethoxy)phenyl}-4-{4-(oxiranylmethoxy)phenyl}-2,5-cyclohexadiene,
1-{3-n-heptyl-4-(oxiranylmethoxy)phenyl}-4-{4-(oxiranylmethoxy)phenyl}-2,5-cyclohexadiene,
1-{3-n-octyl-4-(oxiranylmethoxy)phenyl}-4-{4-(oxiranylmethoxy)phenyl}-2,5-cyclohexadiene,
1-{3-(2-ethylhexyl)-4-(oxiranylmethoxy)phenyl}-4-{4-(oxiranylmethoxy)phenyl}-2,5-cyclohexadiene,
1-{3-tert-octyl-4-(oxiranylmethoxy)phenyl}-4-{4-(oxiranylmethoxy)phenyl}-2,5-cyclohexadiene,
1-{3-cyclooctyl-4-(oxiranylmethoxy)phenyl}-4-{4-(oxiranylmethoxy)phenyl}-2,5-cyclohexadiene,
1-{3-methyl-4-(2-methyl-oxiranylmethoxy)phenyl}-4-{4-(2 methyl-oxiranylmethoxy)phenyl}-2,5-cyclohexadiene,
1-{3-methyl-4-(3-methyl-oxiranylmethoxy)phenyl}-4-{4-(3-methyl-oxiranylmethoxy)phenyl}-2,5-cyclohexadiene,
4-bis{4-(oxiranylmethoxy)phenyl}-1,5-cyclohexadiene,
1-{2-methyl-4-(oxiranylmethoxy)phenyl}-4-{4-(oxiranylmethoxy)phenyl}-1,5-cyclohexadiene,
1-{3-methyl-4-(oxiranylmethoxy)phenyl}-4-{4-(oxiranylmethoxy)phenyl}-1,5-cyclohexadiene,
1-{3-ethyl-4-(oxiranylmethoxy)phenyl}-4-{4-(oxiranylmethoxy)phenyl}-1,5-cyclohexadiene,
1-{3-n-propyl-4-(oxiranylmethoxy)phenyl}-4-{4-(oxiranylmethoxy)phenyl}-1,5-cyclohexadiene,
1-{3-isopropyl-4-(oxiranylmethoxy)phenyl}-4-{4-(oxiranylmethoxy)phenyl}-1,5-cyclohexadiene,
1-{3-n-butyl-4-(oxiranylmethoxy)phenyl}-4-{4-(oxiranylmethoxy)phenyl}-1,5-cyclohexadiene,
1-{3-sec-butyl-4-(oxiranylmethoxy)phenyl}-4-{4-(oxiranylmethoxy)phenyl}-1,5-cyclohexadiene,
1-{3-tert-butyl-4-(oxiranylmethoxy)phenyl}-4-{4-(oxiranylmethoxy)phenyl}-1,5-cyclohexadiene,
1-{3-n-pentyl-4-(oxiranylmethoxy)phenyl}-4-{4-(oxiranylmethoxy)phenyl}-1,5-cyclohexadiene,
1-{3-tert-pentyl-4-(oxiranylmethoxy)phenyl}-4-{4-(oxiranylmethoxy)phenyl}-1,5-cyclohexadiene,
1-{3-n-hexyl-4-(oxiranylmethoxy)phenyl}-4-{4-(oxiranylmethoxy)phenyl}-1,5-cyclohexadiene,
1-{3-(1-methylpentyl)-4-(oxiranylmethoxy)phenyl}-4-{4-(oxiranylmethoxy)phenyl}-1,5-cyclohexadiene,
1-{3-(1-ethylbutyl)-4-(oxiranylmethoxy)phenyl}-4-{4-(oxiranylmethoxy)phenyl}-1,5-cyclohexadiene,
1-{3-cyclohexyl-4-(oxiranylmethoxy)phenyl}-4-{4-(oxiranylmethoxy)phenyl}-1,5-cyclohexadiene,
1-{3-n-heptyl-4-(oxiranylmethoxy)phenyl}-4-{4-(oxiranylmethoxy)phenyl}-1,5-cyclohexadiene,
1-{3-n-octyl-4-(oxiranylmethoxy)phenyl}-4-{4-(oxiranylmethoxy)phenyl}-1,5-cyclohexadiene,
1-{3-(2-ethylhexyl)-4-(oxiranylmethoxy)phenyl}-4-{4-(oxiranylmethoxy)phenyl}-1,5-cyclohexadiene,
1-{3-tert-octyl-4-(nxiranylmethoxy)phenyl}-4-{4-(oxiranylmethoxy)phenyl}-1,5-cyclohexadiene,
1-{3-cyclooctyl-4-(oxiranylmethoxy)phenyl}-4-{4-(oxiranylmethoxy)phenyl}-1,5-cyclohexadiene,
1-{3-methyl-4-(2-methyl-oxiranylmethoxy)phenyl}-4-{4-(2-methyl-oxiranylmethoxy)phenyl}-1,5-cyclohexadiene,
1-{3-methyl-4-(3-methyl-oxiranylmethoxy)phenyl}-4-{4-(3-methyl-oxiranylmethoxy)phenyl}-1,5-cyclohexadiene,
4-bis{4-(oxiranylmethoxy)phenyl}-1,4-cyclohexadiene,
1-{2-methyl-4-(oxiranylmethoxy)phenyl}-4-{4-(oxiranylmethoxy)phenyl}-1,4-cyclohexadiene,
1-{3-methyl-4-(oxiranylmethoxy)phenyl}-4-{4-(oxiranylmethoxy)phenyl}-1,4-cyclohexadiene,
1-{3-ethyl-4-(oxiranylmethoxy)phenyl}-4-{4-(oxiranylmethoxy)phenyl}-1,4-cyclohexadiene,
1-{3-n-propyl-4-(oxiranylmethoxy)phenyl}-4-{4-(oxiranylmethoxy)phenyl}-1,4-cyclohexadiene,
1-{3-isopropyl-4-(oxiranylmethoxy)phenyl}-4-{4-(oxiranylmethoxy)phenyl}-1,4-cyclohexadiene,
1-{3-n-butyl-4-(oxiranylmethoxy)phenyl}-4-{4-(oxiranylmethoxy)phenyl}-1,4-cyclohexadiene,
1-{3-sec-butyl-4-(oxiranylmethoxy)phenyl}-4-{4-(oxiranylmethoxy)phenyl}-1,4-cyclohexadiene,
1-{3-tert-butyl-4-(oxiranylmethoxy)phenyl}-4-{4-(oxiranylmethoxy)phenyl}-1,4-cyclohexadiene,
1-{3-n-pentyl-4-(oxiranylmethoxy)phenyl}-4-{4-(oxiranylmethoxy)phenyl}-1,4-cyclohexadiene,
1-{3-tert-pentyl-4-(oxiranylmethoxy)phenyl}-4-{4-(oxiranylmethoxy)phenyl}-1,4-cyclohexadiene,
1-{3-n-hexyl-4-(oxiranylmethoxy)phenyl}-4-{4-(oxiranylmethoxy)phenyl}-1,4-cyclohexadiene,
1-{3-(1-methylpentyl)-4-(oxiranylmethoxy)phenyl}-4-{4-(oxiranylmethoxy)phenyl}-1,4-cyclohexadiene,
1-{3-(1-ethylbutyl)-4-(oxiranylmethoxy)phenyl}-4-{4-(oxiranylmethoxy)phenyl}-1,4-cyclohexadiene,
1-{3-cyclohexyl-4-(oxiranylmethoxy)phenyl}-4-{4-(oxiranylmethoxy)phenyl}-1,4-cyclohexadiene,
1-{3-n-heptyl-4-(oxiranylmethoxy)phenyl}-4-(4-(oxiranylmethoxy)phenyl}-1,4-cyclohexadiene,
1-{3-n-octyl-4-(oxiranylmethoxy)phenyl}-4-{4-(oxiranylmethoxy)phenyl}-1,4-cyclohexadiene,
1-{3-(2-ethylhexyl)-4-(oxiranylmethoxy)phenyl}-4-{4-(oxiranylmethoxy)phenyl}-1,4-cyclohexadiene,
1-{3-tert-octyl-4-(oxiranylmethoxy)phenyl}-4-{4-(oxiranylmethoxy)phenyl}-1,4-cyclohexadiene,
1-{3-cyclooctyl-4-(oxiranylmethoxy)phenyl}-4-{4-(oxiranylmethoxy)phenyl}-1,4-cyclohexadiene,
1-{3-methyl-4-(2-methyl-oxiranylmethoxy)phenyl}-4-{4-(2-methyl-oxiranylmethoxy)phenyl}-1,4-cyclohexadiene,
1-{3-methyl-4-(3-methyl-oxiranylmethoxy)phenyl}-4-{4-(3-methyl-oxiranylmethoxy)phenyl}-1,4-cyclohexadiene,
4-bis{4-(oxiranylmethoxy)phenyl}-1,3-cyclohexadiene,
1-{2-methyl-4-(oxiranylmethoxy)phenyl}-4-{4-(oxiranylmethoxy)phenyl}-1,3-cyclohexadiene,
1-{3-methyl-4-(oxiranylmethoxy)phenyl}-4-{4-(oxiranylmethoxy)phenyl}-1,3-cyclohexadiene,
1-{3-ethyl-4-(oxiranylmethoxy)phenyl}-4-{4-(oxiranylmethoxy)phenyl}-1,3-cyclohexadiene,
1-{3-n-propyl-4-(oxiranylmethoxy)phenyl}-4-{4-(oxiranylmethoxy)phenyl}-1,3-cyclohexadiene,
1-{3-isopropyl-4-(oxiranylmethoxy)phenyl}-4-{4-(oxiranylmethoxy)phenyl}-1,3-cyclohexadiene,
1-{3-n-butyl-4-(oxiranylmethoxy)phenyl}-4-{4-(oxiranylmethoxy)phenyl}-1,3-cyclohexadiene,
1-{3-sec-butyl-4-(oxiranylmethoxy)phenyl}-4-{4-(oxiranylmethoxy)phenyl}-1,3-cyclohexadiene,
1-{3-tert-butyl-4-(oxiranylmethoxy)phenyl}-4-{4-(oxiranylmethoxy)phenyl}-1,3-cyclohexadiene,
1-{3-n-pentyl-4-(oxiranylmethoxy)phenyl}-4-{4-(oxiranylmethoxy)phenyl}-1,3-cyclohexadiene,
1-{3-tert-pentyl-4-(oxiranylmethoxy)phenyl}-4-{4-(oxiranylmethoxy)phenyl}-1,3-cyclohexadiene,
1-{3-n-hexyl-4-(oxiranylmethoxy)phenyl}-4-{4-(oxiranylmethoxy)phenyl}-1,3-cyclohexadiene,
1-{3-(1-methylpentyl)-4-(oxiranylmethoxy)phenyl}-4-{4-(oxiranylmethoxy)phenyl}-1,3-cyclohexadiene,
1-{3-(1-ethylbutyl)-4-(oxiranylmethoxy)phenyl}-4-{4-(oxiranylmethoxy)phenyl}-1,3-cyclohexadiene,
1-(3-cyclohexyl-4-(oxiranylmethoxy)phenyl}-4-{4-(oxiranylmethoxy)phenyl}-1,3-cyclohexadiene,
1-{3-n-heptyl-4-(oxiranylmethoxy)phenyl}-4-{4-(oxiranylmethoxy)phenyl}-1,3-cyclohexadiene,
1-{3-n-octyl-4-(oxiranylmethoxy)phenyl}-4-{4-(oxiranylmethoxy)phenyl}-1,3-cyclohexadiene,
1-{3-(2-ethylhexyl)-4-(oxiranylmethoxy)phenyl}-4-{4-(oxiranylmethoxy)phenyl}-1,3-cyclohexadiene,
1-{3-tert-octyl-4-(oxiranylmethoxy)phenyl}-4-{4-(oxiranylmethoxy)phenyl}-1,3-cyclohexadiene,
1-{3-cyclooctyl-4-(oxiranylmethoxy)phenyl}-4-{4-(oxiranylmethoxy)phenyl}-1,3-cyclohexadiene,
1-{3-methyl-4-(2-methyl-oxiranylmethoxy)phenyl}-4-{4-(2-methyl-oxiranylmethoxy)phenyl}-1,3-cyclohexadiene,
1-{3-methyl-4-(3-methyl-oxiranylmethoxy)phenyl}-4-{4-(3-methyl-oxiranylmethoxy)phenyl}-1,3-cyclohexadiene,
4-bis{4-(oxiranylmethoxy)phenyl}benzene,
1-{2-methyl-4-(oxiranylmethoxy)phenyl}-4-{4-(oxiranylmethoxy)phenyl}benzene,
1-{3-methyl-4-(oxiranylmethoxy)phenyl}-4-{4-(oxiranylmethoxy)phenyl}benzene,
1-{3-ethyl-4-(oxiranylmethoxy)phenyl}-4-{4-(oxiranylmethoxy)phenyl}-benzene,
1-{3-n-propyl-4-(oxiranylmethoxy)phenyl}-4-{4-(oxiranylmethoxy)phenyl}-benzene,
1-{3-isopropyl-4-(oxiranylmethoxy)phenyl}-4-{4-(oxiranylmethoxy)phenyl}-benzene,
1-{3-n-butyl-4-(oxiranylmethoxy)phenyl}-4-{4-(oxiranylmethoxy)phenyl}-benzene,
1-{3-sec-butyl-4-(oxiranylmethoxy)phenyl}-4-{4-(oxiranylmethoxylphenyl}-benzene,
1-{3-tert-butyl-4-(oxiranylmethoxy)phenyl}-4-{4-(oxiranylmethoxy)phenyl}-benzene,
1-{3-n-pentyl-4-(oxiranylmethoxy)phenyl}-4-{4-(oxiranylmethoxy)phenyl}-benzene,
1-{3-tert-pentyl-4-(oxiranylmethoxy)phenyl}-4-{4-(oxiranylmethoxy)phenyl}-benzene,
1-{3-n-hexyl-4-(oxiranylmethoxy)phenyl}-4-{4-(oxiranylmethoxy)phenyl}-benzene,
1-{3-(1-methylpentyl)-4-(oxiranylmethoxy)phenyl}-4-{4-(oxiranylmethoxy)phenyl}-benzene,
1-{3-(1-ethylbutyl)-4-(oxiranylmethoxy)phenyl}-4-{4-(oxiranylmethoxy)phenyl}-benzene,
1-{3-cyclohexyl-4-(oxiranylmethoxy)phenyl}-4-{4-(oxiranylmethoxy)phenyl}-benzene,
1-{3-n-heptyl-4-(oxiranylmethoxy)phenyl}-4-{4-(oxiranylmethoxy)phenyl}-benzene,
1-{3-n-octyl-4-(oxiranylmethoxy)phenyl}-4-{4 (oxiranylmethoxy)phenyl}-benzene,
1-{3-(2-ethylhexyl)-4-(oxiranylmethoxy)phenyl}-4-{4-(oxiranylmethoxy)phenyl}-benzene,
1-{3-tert-octyl-4-(oxiranylmethoxy)phenyl}-4-{4-(oxiranylmethoxy)phenyl}-benzene,
1-{3-cyclooctyl-4-(oxiranylmethoxy)phenyl}-4-{4-(oxiranylmethoxy)phenyl}-benzene,
1-{3-methyl-4-(2-methyl-oxiranylmethoxy)phenyl}-4-{4-(2-methyl-oxiranylmethoxy)phenyl}-benzene,
1-{3-methyl-4-(3-methyl-oxiranylmethoxy)phenyl}-4-{4-(3-methyl-oxiranylmethoxy)phenyl}-benzene,
1,4-bis{4-(oxiranylmethoxyethoxy)phenyl}-cyclohexane,
1-{3-methyl-4-(oxiranylmethoxyethoxy)phenyl}-4-{4-(oxiranylmethoxyethoxy)phenyl}-cyclohexane,
1,4-bis{4-(3-oxiranylpropoxy)phenyl}-cyclohexane,
1-{3-methyl-4-(3-oxiranylpropoxy)phenyl}-4-{4-(3-oxiranylpropoxy)phenyl}-cyclohexane,
1,4-bis{4-(4-oxiranylbutoxy)phenyl}-cyclohexane,
1-{3-methyl-4-(4-oxiranylbutoxy)phenyl}-4-{4-(4-oxiranylbutoxy)phenyl}-cyclohexane,
1,4-bis{4-(5-oxiranylpentyloxy)phenyl}-cyclohexane,
1-{3-methyl-4-(5-oxiranylpentyloxy)phenyl}-4-{4-(5-oxiranylpentyloxy)phenyl}-cyclohexane,
1,4-bis{4-(6-oxiranylhexyloxy)phenyl}-cyclohexane,
1-{3-methyl-4-(6-oxiranylhexyloxy)phenyl}-4-{4-(6-oxiranylhexyloxy)phenyl}-cyclohexane,
1,4-bis{4-(8-oxiranyloctyloxy)phenyl}-cyclohexane,
1-{3-methyl-4-(8-oxiranyloctyloxy)phenyl}-4-{4-(8-oxiranyloctyloxy)phenyl}-cyclohexane,
1,4-bis{4-(oxiranylmethoxyethoxy)phenyl}-cyclohexane,
1-{3-methyl-4-(oxiranylmethoxyethoxy)phenyl}-4-{4-(oxiranylmethoxyethoxy)phenyl}-cyclohexane,
1,4-bis{4-(2-methyl-oxiranyl)methoxyethoxyphenyl}-cyclohexane,
1-{3-methyl-4-(2-methyl-oxiranyl)methoxyethoxyphenyl}-4-{4-(2-methyl-oxiranyl)methoxyethoxyphenyl}-cyclohexane,
1,4-bis{4-(3-methyl-oxiranyl)methoxyethoxyphenyl}-cyclohexane,
1-{3-methyl-4-(3-methyl-oxiranyl)methoxyethoxyphenyl}-4-{4-(3-methyl-oxiranyl)methoxyethoxyphenyl}-cyclohexane,
1,4-bis{4-(oxiranylethoxy)phenyl}-1-cyclohexene,
1-{3-methyl-4-(oxiranylethoxy)phenyl}-4-{4-(oxiranylethoxy)phenyl}-1-cyclohexene,
1,4-bis{4-(3-oxiranylpropoxy)phenyl}-1-cyclohexene,
1-{3-methyl-4-(3-oxiranylpropoxy)phenyl}-4-{4-(3-oxiranylpropoxy)phenyl}-1-cyclohexene,
1,4-bis{4-(4-oxiranylbutoxy)phenyl}-1-cyclohexene,
1-{3-methyl-4-(4-oxiranylbutoxy)phenyl}-4-{4-(4-oxiranylbutoxy)phenyl)-1-cyclohexene,
1,4-bis{4-(5-oxiranylpentyloxy)phenyl}-1-cyclohexene,
1-{3-methyl-4-(5-oxiranylpentyloxy)phenyl}-4-{4-(5-oxiranylpentyloxy)phenyl}-1-cyclohexene,
1,4-bis{4-(6-oxiranylhexyloxy)phenyl}-1-cyclohexene,

1-{3-methyl-4-(6-oxiranylhexyloxy)phenyl}-4-{4-(6-oxiranylhexyloxy)phenyl}-1-cyclohexene,
1,4-bis{4-(8-oxiranyloctyloxy)phenyl}-1-cyclohexene,
1-{3-methyl-4-(8-oxiranyloctyloxy)phenyl}-4-{4-(8-oxiranyloctyloxy)phenyl}-1-cyclohexene,
1,4-bis{4-(oxiranylmethoxyethoxy)phenyl}-1-cyclohexene,
1-{3-methyl-4-(oxiranylmethoxyethoxy)phenyl}-4-{4-(oxiranylmethoxyethoxy)phenyl}-1-cyclohexene,
1,4-bis{4-(2-methyl-oxiranyl)methoxyethoxyphenyl}-1-cyclohexene,
1-{3-methyl-4-(2-methyl-oxiranyl)methoxyethoxyphenyl}-4-{4-(2-methyl-oxiranyl)methoxyethoxyphenyl}-1-cyclohexene,
1,4-bis{4-(3-methyl-oxiranyl)methoxyethoxyphenyl}-1-cyclohexene,
1-{3-methyl-4-(3-methyl-oxiranyl)methoxyethoxyphenyl}-4-{4-(3-methyl-oxiranyl)methoxyethoxyphenyl}-1-cyclohexene,
1,4-bis{4-(oxiranylmethoxyethoxy)phenyl}-benzene,
1-{3-methyl-4-(oxiranylmethoxyethoxy)phenyl}-4-{4-(oxiranylmethoxyethoxy)phenyl}-benzene,
1,4-bis{4-(3-oxiranylpropoxy)phenyl}-benzene,
1-{3-methyl-4-(3-oxiranylpropoxy)phenyl}-4-{4-(3-oxiranylpropoxy)phenyl}-benzene,
1,4-bis{4-(4-oxiranylbutoxy)phenyl}-benzene,
1-{3-methyl-4-(4-oxiranylbutoxy)phenyl}-4-{4-(4-oxiranylbutoxy)phenyl}-benzene,
1,4-bis{4-(5-oxiranylpentyloxy)phenyl}-benzene,
1-{3-methyl-4-(5-oxiranylpentyloxy)phenyl}-4-{4-(5-oxiranylpentyloxy)phenyl}-benzene,
1,4-bis{4-(6-oxiranylhexyloxy)phenyl}-benzene,
1-{3-methyl-4-(6-oxiranylhexyloxy)phenyl}-4-{4-(6-oxiranylhexyloxy)phenyl}-benzene,
1,4-bis{4-(8-oxiranyloctyloxy)phenyl}-benzene,
1-{3-methyl-4-(8-oxiranyloctyloxy)phenyl}-4-{4-(8-oxiranyloctyloxy)phenyl}-benzene,
1,4-bis{4-(oxiranylmethoxyethoxy)phenyl}-benzene,
1-{3-methyl-4-(oxiranylmethoxyethoxy)phenyl}-4-{4-(oxiranylmethoxyethoxy)phenyl}-benzene,
1,4-bis{4-(2-methyl-oxiranyl)methoxyethoxyphenyl}-benzene,
1-{3-methyl-4-(2-methyl-oxiranyl)methoxyethoxyphenyl}-4-{4-(2-methyl-oxiranyl)methoxyethoxyphenyl}-benzene,
1,4-bis{4-(3-methyl-oxiranyl)methoxyethoxyphenyl}-benzene and
1-{3-methyl-4-(3-methyl-oxiranyl)methoxyethoxyphenyl}-4-{4-(3-methyl-oxiranyl)methoxyethoxyphenyl}-benzene.

Among these epoxy compounds,
1,4-bis{4-(oxiranylmethoxy)phenyl}-1-cyclohexene,
1-{3-methyl-4-(oxiranylmethoxy)phenyl}-4-{4-(oxiranylmethoxy)phenyl}-1-cyclohexene,
1-{3-ethyl-4-(oxiranylmethoxy)phenyl}-4-{4-(oxiranylmethoxy)phenyl}-1-cyclohexene,
1-{3-n-propyl-4-(oxiranylmethoxy)phenyl}-4-{4-(oxiranylmethoxy)phenyl}-1-cyclohexene,
1-{3-isopropyl-4-(oxiranylmethoxy)phenyl}-4-{4-(oxiranylmethoxy)phenyl}-1-cyclohexene,
1-(3-n-butyl-4-(oxiranylmethoxy)phenyl}-4-{4-(oxiranylmethoxy)phenyl}-1-cyolohexene,
1-{3-sec-butyl-4-(oxiranylmethoxy)phenyl}-4-{4-(oxiranylmethoxy)phenyl}-1-cyclohexene,
1-{3-tert-butyl-4-(oxiranylmethoxy)phenyl}-4-{4-(oxiranylmethoxy)phenyl}-1-cyclohexene, 1,4-bis{4-(oxiranylmethoxyethoxy)phenyl}-1-cyclohexene,
1-{3-methyl-4-(oxiranylmethoxyethoxy)phenyl}-4-{4-(oxiranylmethoxyethoxy)phenyl}-1-cyclohexene,
1-{3-ethyl-4-(oxiranylmethoxyethoxy)phenyl}-4-{4-(oxiranylmethoxyethoxy)phenyl}-1-cyclohexene,
1-{3-n-propyl-4-(oxiranylmethoxyethoxy)phenyl}-4-{4-(oxiranylmethoxyethoxy)phenyl}-1-cyclohexene,
1-{3-isopropyl-4-{oxiranylmethoxyethoxy)phenyl}-4-{4-(oxiranylmethoxyethoxy)phenyl}-1-cyclohexene,
1-{3-n-butyl-4-(oxiranylmethoxyethoxy)phenyl}-4-{4-(oxiranylmethoxyethoxy)phenyl}-1-cyclohexene,
1-{3-sec-butyl-4-(oxiranylmethoxyethoxy)phenyl}-4-{4-(oxiranylmethoxyethoxy)phenyl}-1-cyclohexene,
1-{3-tert-butyl-4-(oxiranylmethoxyethoxy)phenyl}-4-{4-(oxiranylmethoxyethoxy)phenyl}-1-cyclohexene,
1,4-bis{4-(oxiranylmethoxy)phenyl}-benzene,
1-{3-methyl-4-(oxiranylmethoxy)phenyl}-4-{4-(oxiranylmethoxy)phenyl}-benzene,
1-{3-ethyl-4-(oxiranylmethoxy)phenyl}-4-{4-(oxiranylmethoxy)phenyl}-benzene,
1-{3-n-propyl-4-(oxiranylmethoxy)phenyl}-4-{4-(oxiranylmethoxy)phenyl}-benzene,
1-(3-isopropyl-4-(oxiranylmethoxy)phenyl}-4-{4-(oxiranylmethoxy)phenyl}-benzene,
1-{3-n-butyl-4-(oxiranylmethoxy)phenyl}-4-{4-(oxiranylmethoxy)phenyl}-benzene,
1-{3-sec-butyl-4-(oxiranylmethoxy)phenyl}-4-{4-(oxiranylmethoxy)phenyl}-benzene,
1-{3-tert-butyl-4-(oxiranylmethoxy)phenyl}-4-{4-(oxiranylmethoxy)phenyl}-benzene,
1,4-bis{4-(oxiranylmethoxyethoxy)phenyl}-benzene,
1-{3-methyl-4-(oxiranylmethoxyethoxy)phenyl}-4-{4-(oxiranylmethoxyethoxy)phenyl}-benzene,
1-{3-ethyl-4-(oxiranylmethoxyethoxy)phenyl}-4-{4-(oxiranylmethoxyethoxy)phenyl}-benzene,
1-{3-n-propyl-4-(oxiranylmethoxyethoxy)phenyl}-4-{4-(oxiranylmethoxyethoxy)phenyl}-benzene,
1-(3-isopropyl-4-(oxiranylmethoxyethoxy)phenyl}-4-{4-(oxiranylmethoxyethoxy)phenyl}-benzene,
1-(3-n-butyl-4-(oxiranylmethoxyethoxy)phenyl}-4-{4-(oxiranylmethoxyethoxy)phenyl}-benzene,
1-{3-sec-butyl-4-(oxiranylmethoxyethoxylphenyl}-4-{4-(oxiranylmethoxyethoxy)phenyl}-benzene and
1-{3-tert-butyl-4-(oxiranylmethoxyethoxy)phenyl}-4-{4-(oxiranylmethoxyethoxy)phenyl}-benzene are preferred.

The epoxy compound (1) can be produced, for example, by the method described in EP 1698625 A1.

Subsequently, the epoxy compound (2) will be explained.
Examples of the alkyl group having 1 to 8 carbon atoms include a straight-chain or branched-chain alkyl group having 1 to 8 carbon atoms such as methyl, ethyl, n-propyl, isopropyl, n-butyl, isobutyl, sec-butyl, tert-butyl, n-pentyl, tert-amyl, n-hexyl, n-octyl, isooctyl and tert-octyl group. Examples of the straight-chain alkylene group having 1 to 8 carbon atoms include groups formed by bonding 1 to 8 methylene groups linearly, such as methylene, ethylene, trimethylene, tetramethylene, hexamethylene and octamethylene group. The methylene groups composing the straight-chain alkylene group having 1 to 8 carbon atoms are optionally substituted with an alkyl group having 1 to 8 carbon atoms, and specific examples thereof include 2-methyltrimethylene and 1,2-dimethylpropylene group.
Q² is preferably a single bond, a methylene group, an ethylene group or a trimethylene group.

Examples of the epoxy compound (2) include:
4,4'-bis(oxiranylmethoxy)biphenyl,
4,4'-bis(2-methyloxiranylmethoxy)biphenyl,
4,4'-bis(3-methyloxiranylmethoxy)biphenyl,
4,4'-bis(oxiranylmethoxyethoxy)biphenyl,
4,4'-bis(2-oxiranylethoxy)biphenyl,
4,4'-bis(3-oxiranylpropoxy)biphenyl,
4,4'-bis(4-oxiranylbutoxy)biphenyl,
4,4'-bis(4-oxiranylpentyloxy)biphenyl,
4,4'-bis(4-oxiranylhexyloxy)biphenyl,
4,4'-bis(4-oxiranylheptyloxy)biphenyl,
4,4'-bis(4-oxiranyloctyloxy)biphenyl,
4,4'-bis(4-oxiranylmethoxyethoxy)biphenyl,
bis(4-oxiranylmethoxyphenyl)methane
bis(2-methyloxiranylmethoxy)methane,
bis(3-methyloxiranylmethoxy)methane,
bis(oxiranylmethoxyethoxy)methane,
bis(2-oxiranylethoxy)methane,
bis(3-oxiranylpropoxy)methane,
bis(4-oxiranylbutoxy)methane,
bis(4-oxiranylpentyloxy)methane,
bis(4-oxiranylhexyloxy)methane,
bis(4-oxiranylheptyloxy)methane,
bis(4-oxiranyloctyloxy)methane,
bis(4-oxiranylmethoxyethoxy)methane,
1,2-bis(4-oxiranylmethoxyphenyl)ethane
1,2-bis(2-methyloxiranylmethoxy)ethane,
1,2-bis(3-methyloxiranylmethoxy)ethane,
1,2-bis(oxiranylmethoxyethoxy)ethane,
1,2-bis(2-oxiranylethoxy)ethane,
1,2-bis(3-oxiranylpropoxy)ethane,
1,2-bis(4-oxiranylbutoxy)ethane,
1,2-bis(4-oxiranylpentyloxy)ethane, 1,2-bis(4-oxiranylhexyloxy)ethane,
1,2-bis(4-oxiranylheptyloxy)ethane,
1,2-bis(4-oxiranyloctyloxy)ethane,
1,2-bis(4-oxiranylmethoxyethoxy)ethane,
2,2-bis(4-oxiranylmethoxyphenyl)propane,
2,2-bis(2-methyloxiranylmethoxy)propane,
2,2-bis(3-methyloxiranylmethoxy)propane,
2,2-bis(oxiranylmethoxyethoxy)propane,
2,2-bis(2-oxiranylethoxy)propane,
2,2-bis(3-oxiranylpropoxy)propane,
2-bis(4-oxiranylbutoxy)propane,
2,2-bis(4-oxiranylpentyloxy)propane,
2,2-bis(4-oxiranylhexyloxy)propane,
2,2-bis(4-oxiranylheptyloxy)propane,
2,2-bis(4-oxiranyloctyloxy)propane,
2,2-bis(4-oxiranylmethoxyethoxy)propane,
3,3',5,5'-tetramethyl-4,4'-bis(oxiranylmethoxy)biphenyl,
3,3',5,5'-tetramethyl-4,4'-bis(2-methyloxiranylmethoxy)biphenyl,
3,3', 5, 5'-tetramethyl-4,4'-bis(3-methyloxiranylmethoxy)biphenyl,
3,3',5,5'-tetramethyl-4,4'-bis(oxiranylmethoxyethoxy)biphenyl,
3,3',5,5'-tetramethyl-4,4'-bis(2-oxiranylethoxy)biphenyl,
3,3',5,5'-tetramethyl-4,4'-bis(3-oxiranylpropoxy)biphenyl,
3,3',5,5'-tetramethyl-4,4'-bis(4-oxiranylbutoxy)biphenyl, 3,3',5,5'-tetramethyl-4,4'-bis(4-oxiranylpentyloxy)biphenyl,
3,3',5,5'-tetramethyl-4,4'-bis(4-oxiranylhexyloxy)biphenyl,
3,3',5,5'-tetramethyl-4,4'-bis(4-oxiranylheptyloxy)biphenyl,
3,3',5,5'-tetramethyl-4,4'-bis(4-oxiranyloctyloxy)biphenyl,
3,3',5,5'-tetramethyl-4,4'-bis(4-oxiranylmethoxyethoxy)bipheryl,

3,3',5,5'-tetraethyl-4,4'-bis(oxiranylmethoxy)biphenyl,
3,3',5,5'-tetraethyl-4,4'-bis(2-methyloxiranylmethoxy)biphenyl,
3,3',5,5'-tetraethyl-4,4'-bis(3-methyloxiranylmethoxy)biphenyl,
3,3',5,5'-tetraethyl-4,4'-bis(oxiranyimethoxyethoxy)biphenyl,
3,3', 5,5'-tetraethyl-4,4'-bis(2-oxiranylethoxy)biphenyl,
3,3',5,5'-tetraethyl-4,4'-bis(3-oxiranylpropoxy)biphenyl,
3,3',5,5'-tetraethyl-4,4'-bis(4-oxiranylbutoxy)biphenyl,
3,3',5,5'-tetraethyl-4,4'-bis(4-oxiranylpentyloxy)biphenyl,
3,3',5,5'-tetraethyl-4,4'-bis(4-oxiranylhexyloxy)biphenyl,
3,3',5,5'-tetraethyl-4,4'-bis(4-oxiranylheptyloxy)biphenyl,
3,3',5,5'-tetraethyl-4,4'-bis(4-oxsiranyloctyloxy)biphenyl,
3,3',5,5'-tetraethyl-4,4'-bis(4-oxiranylmethoxyethoxy)biphenyl,
3,3',5,5'-tetra-isopropyl-4,4'-bis(oxiranylmethoxy)biphenyl,
3,3',5,5'-tetra-isopropyl-4,4'-bis(2-methyloxiranylmethoxy)biphenyl,
3,3',5,5'-tetra-isopropyl-4,4'-bis(3-methyloxiranylmethoxy)biphenyl,
3,3',5,5'-tetra-isopropyl-4,4'-bis(oxiranylmethoxyethoxy)biphenyl,
3,3',5,5'-tetra-isopropyl-4,4'-bis(2-oxiranylethoxy)biphenyl,
3,3',5,5'-tetra-isopropyl-4,4'-bis(3-oxiranylpropoxy)biphenyl,
3,3',5,5'-tetra-isopropyl-4,4'-bis(4-oxiranylbutoxy)biphenyl,
3,3',5,5'-tetra-isoprapyl-4,4'-bis(4-oxiranylpentyloxy)biphenyl,
3,3',5,5'-tetra-isopropyl-4,4'-bis(4-oxiranylhexyloxy)biphenyl,
3,3',5,5'-tetra-isopropyl-4,4'-bis(4-oxiranylheptyloxy)biphenyl,
3,3',5,5'-tetra-isopropyl-4,4'-bis(4-oxiranyloctyloxy)biphenyl,
3,3',5,5'-tetra-isopropyl-4,4'-bis(4-oxiranylmethoxyethoxy)biphenyl,
3,3',5,5'-tetra-tert-butyl-4,4'-bis(oxiranylmethoxy)biphenyl,
3,3',5,5'-tetra-tert-butyl-4,4'-bis(2-methyloxiranylmethoxy)biphenyl,
3,3',5,5'-tetra-tert-butyl-4,4'-bis(3-methyloxiranylmethoxy)biphenyl,
3,3',5,5'-tetra-tert-butyl-4,4'-bis(oxiranylmethoxyethoxy)biphenyl,
3,3',5,5'-tetra-tert-butyl-4,4'-bis(2-oxiranylethoxy)biphenyl,
3,3',5,5'-tetra-tert-butyl-4,4'-bis(3-oxiranylpropoxy)biphenyl,
3,3',5,5'-tetra-tert-butyl-4,4'-bis(4-oxiranylbutoxy)biphenyl,
3,3',5,5'-tetra-tert-buty-4,4'-bis(4-oxiranylpentyloxy)biphenyl,
3,3',5,5'-tetra-tert-butyl-4,4'-bis(4-oxiranylhexyloxy)biphenyl,
3,3',5,5'-tetra-tert-butyl-4,4'-bis(4-oxiranylheptyloxy)biphenyl,
3,3',5,5'-tetra-tert-butyl-4,4'-bis(4-oxiranyloctyloxy)biphenyl,
3,3', 5,5'-tetra-t-butyl-4,4'-bis(4-oxiranylmethoxyethoxy)biphenyl,
3,3',5,5'-tetra-tert-pentyl-4,4'-bis(oxiranylmethoxy)biphenyl,
3,3',5,5'-tetra-tert-pentyl-4,4'-bis(2-methyloxiranylmethoxy)biphenyl,
3,3',5,5'-tetra-tert-pentyl-4,4'-bis(3-methyloxiranylmethoxy)biphenyl,
3,3',5,5'-tetra-tert-pentyl-4,4'-bis(oxiranylmethoxyethoxy)biphenyl,
3,3',5,5'-tetra-tert-pentyl-4,4'-bis(2-oxiranylethoxy)biphenyl,
3,3',5,5'-tetra-tert-pentyl-4,4'-bis(3-oxiranylpropoxy)biphenyl,
3,3',5,5'-tetra-tert-pentyl-4,4'-bis(4-oxiranylbutoxy)biphenyl,
3,3',5,5'-tetra-tert-pentyl-4,4'-bis(4-oxiranylpentyloxy)biphenyl,
3,3',5,5'-tetra-tert-pentyl-4,4'-bis(4-oxiranylhexyloxy)biphenyl,
3,3',5,5'-tetra-tert-pentyl-4,4'-bis(4-oxiranylheptyloxy)biphenyl,
3,3',5,5'-tetra-tert-pentyl-4,4'-bis(4-oxiranyloctyloxy)biphenyl,
3,3',5,5'-tetra-tert-pentyl-4,4'-bis(4-oxiranylmethoxyethoxy)biphenyl,
3,3',5,5'-tetra-tert-octyl-4,4'-bis(oxiranylmethoxy)biphenyl,
3,3',5,5'-tetra-tert-octyl-4,4'-bis(2-methyloxiranylmethoxy)biphenyl,
3,3',5,5'-tetra-tert-octyl-4,4'-bis(3-methyloxiranylmethoxy)biphenyl,
3,3',5,5'-tetra-tert-octyl-4,4'-bis(oxiranylmethoxyethoxy)biphenyl,
3,3',5,5'-tetra-tert-octyl-4,4'-bis(2-oxiranylethoxy)biphenyl,
3,3',5,5'-tetra-tert-octyl-4,4'-bis(3-oxiranylpropoxy)biphenyl,
3,3',5,5'-tetrta-tert-octyl-4,4'-bis(4-oxiranyibutoxy)biphenyl,
3,3',5,5'-tetra-tert-octyl-4,4'-bis4-oxiranylpentyloxy)bipheny,
3,3',5,5'-tetra-tert-octyl-4,4'-bis(4-oxiranylhexyloxy)biphenyl,
3,3',5,5'-tetra-tert-octyl-4,4'-bis(4-oxiranylheptyloxy)biphenyl,
3,3',5,5'-tetra-tert-octyl-4,4'-bis(4-oxiranyloctyloxy)biphenyl,
3,3',5,5'-tetra-tert-octyl-4,4'-bis(4-oxiranylmethoxyethoxy)biphenyl,
bis(3,5-dimethyl-4-oxiranylmethoxyphenyl)methane,
bis(3,5-dimethyl-4-(2-methyloxiranylmethoxy)phenyl)methane,
bis(3,5-dimethyl-4-(3-methyloxiranylmethoxy)phenyl)methane,
bis(3,5-dimethyl-4-(oxiranylmethoxyethoxy)phenyl)methane,
bis(3,5-dimethyl-4-(2-oxiranylethoxy)phenyl)methane,
bis(3,5-dimethyl-4-(3-oxiranylpropoxy)phenyl)methane,
bis(3,5-dimethyl-4-(4-oxiranylbutoxy)phenyl)methane,
bis(3,5-dimethyl-4-(4-oxiranylpentyloxy)phenyl)methane,
bis(3,5-dimethyl-4-(4-oxiranylhexyloxy)phenyl)methane,
bis(3,5-dimethyl-4-(4-oxiranylheptyloxy)phenyl)methane,
bis(3,5-dimethyl-4-(4-oxiranyloctyloxy)phenyl)methane,
bis(3,5-dimethyl-4-(4-oxiranylmethoxyethoxy)phenyl)methane,
bis(3,5-diethyl-4-oxiranylmethoxyphenyl)methane,
bis(3,5-diethyl-4-(2-methyloxiranylmethoxy)phenyl)methane,
bis(3,5-diethyl-4-(3-methyloxiranylmethoxy)phenyl)methane,
bis(3,5-diethyl-4-oxiranylmethoxyethoxyphenyl)methane,
bis(3,5-diethyl-4-(2-oxiranylethoxy)phenyl)methane,
bis(3,5-diethyl-4-(3-oxiranylpropoxy)phenyl)methane, bis(3,5-diethyl-4-(4-oxiranylbutoxy)phenyl)methane,
bis(3,5-diethyl-4-(4-oxiranylpentyloxy)phenyl)methane,
bis(3,5-diethyl-4-(4-oxiranylhexyloxy)phenyl)methane,
bis(3,5-diethyl-4-(4-oxiranylheptyloxy)phenyl)methane,
his(3,5-diethyl-4-(4-oxiranyloctyloxy)phenyl)methane,
bis(3,5-diethyl-4-(4-oxiranylmethoxyethoxy)phenyl)methane,
bis(3,5-diisopropyl-4-(oxiranylmethoxy)phenyl)methane,
bis(3,5-diisopropyl-4-(2-methyloxiranylmethoxy)phenyl)methane,
bis(3,5-diisopropyl-4-(3-methyloxiranylmethoxy)phenyl)methane,
bis(3,5-diisopropyl-4-oxiranylmethoxyethoxyphenyl)methane,
bis(3,5-diisopropyl-4-(2-oxiranylethoxy)phenyl)methane,
bis(3,5-diisopropyl-4-(3-oxiranylpropoxy)phenyl)methane,
bis(3,5-diisopropyl-4-(4-oxiranylbutoxy)phenyl)methane,
bis(3,5-diisopropyl-4-(4-oxiranylpentyloxy)phenyl)methane,
bis(3,5-diisopropyl-4-(4-oxiranylhexyloxy)phenyl)methane,
bis(3,5-diisopropyl-4-(4-oxiranylheptyloxy)phenyl)methane,
bis(3,5-diisopropyl-4-(4-oxiranyloctyloxy)phenyl)methane,
bis(3,5-diisopropyl-4-(4-oxiranylmethoxyethoxy)phenyl)methane,
bis(3,5-di-tert-butyl-4-oxiranylmethoxyphenyl)methane,
bis(3,5-di-tert-butyl-4-(2-methyloxiranylmethoxy)phenyl)methane,
bis(3,5-di-tert-butyl-4-(3-methyloxiranylmethoxy)phenyl)methane,
bis(3,5-di-tert-butyl-4-oxiranylmethoxyethoxyphenyl)methane,
bis(3,5-di-tert-butyl-4-(2-oxiranylethoxy)phenyl)methane,
bis(3,5-di-tert-butyl-4-(3-oxiranylpropoxy)phenyl)methane,
bis(3,5-di-tert-butyl-4-(4-oxiranylbutoxy)phenyl)methane,
bis(3,5-di-tert-butyl-4-(4-oxiranylpentyloxy)phenyl)methane,
bis(3,5-di-tert-butyl-4-(4-oxiranylhexyloxy)phenyl)methane,
bis(3,5-di-tert-butyl-4-(4-oxiranylheptyloxy)phenyl)methane,
bis(3,5-di-tert-butyl-4-(4-oxiranyloctyloxy)phenyl)methane,
bis(3,5-di-tert-butyl-4-(4-oxiranylmethoxyethoxy)phenyl)methane,
bis(3,5-di-tert-pentyl-4-oxiranylmethoxyphenyl)methane,
bis(3,5-di-tert-pentyl-4-(2-methyloxiranylmethoxy)phenyl)methane,
bis(3,5-di-tert-pentyl-4-(3-methyloxiranylmethoxy)phenyl)methane,
bis(3,5-di-tert-pentyl-4-oxiranylmethoxyethoxyphenyl)methane,
bis(3,5-di-tert-pentyl-4-(2-oxiranylethoxy)phenyl)methane,
bis(3,5-di-tert-pentyl-4-(3-oxiranylpropoxy)phenyl)methane,
bis(3,5-di-tert-pentyl-4-(4-oxiranylbutoxy)phenyl)methane,
bis(3,5-di-tert-pentyl-4-(4-oxiranylpentyloxy)phenyl)methane,
bis(3,5-di-tert-pentyl-4-(4-oxiranylhexyloxy)phenyl)methane,
bis(3,5-di-tert-pentyl-4-(4-oxiranylheptyloxy)phenyl)methane,
bis(3,5-di-tert-pentyl-4-(4-oxiranyloctyloxy)phenyl)methane,

bis(3,5-di-tert-pentyl-4-(4-oxiranylmethoxyethoxy)phenyl)methane,
bls(3,5-di-tert-octyl-4-oxiranylmethoxyphenyl)methane,
bis(3,5-di-tert-octyl-4-(2-methyloxlranylmethoxy)phenyl)methane,
bis(3,5-di-tert-octyl-4-(3-methyloxiranylmethoxy)phenyl)methane,
bis(3,5-di-tert-octyl-4-oxiranylmethoxyethoxyphenyl)methane,
bis(3,5-di-tert-octyl-4-(2-oxiranylethoxy)phenyl)methane,
bis(3,5-di-tert-octyl-4-(3-oxiranylpropoxy)phenyl)methane,
bis(3,5-di-tert-octyl-4-(4-oxiranylbutoxy)phenyl)methane,
bis(3,5-di-tert-octyl-4-(4-oxiranylpentyloxy)phenyl)methane,
bis(3,5-di-tert-octyl-4-(4-oxiranylhexyloxy)phenyl)methane,
bis(3,5-di-tert-octyl-4-(4-oxiranylheptyloxy)phenyl)methane,
bis(3,5-di-tert-octyl-4-(4-oxiranyloctyloxy)phenyl)methane,
bis(3,5-di-tert-octyl-4-(4-oxiranylmethoxyethoxy)phenyl)methane,
1,2-bis(3,5-dimethyl-4-oxiranylmethoxyphenyl)ethane,
1,2-bis(3,5-dimethyl-4-(2-methyloxiranylmethoxy)phenyl)ethane,
1,2-bis(3,5-dimethyl-4-(3-methyloxiranylmethoxy)phenyl)ethane,
1,2-bis(3,5-dimethyl-4-(oxiranylmethoxyethoxy)phenyl)ethane,
1,2-bis(3,5-dimethyl-4-(2-oxiranylethoxy)phenyl)ethane,
1,2-bis(3,5-dimethyl-4-(3-oxiranylpropoxy)phenyl)ethane,
1,2-bis(3,5-dimethyl-4-(4-oxiranylbutoxy)phenyl)ethane,
1,2-bis(3,5-dimethyl-4-(4-oxiranylpentyloxy)phenyl)ethane,
1,2-bis(3,5-dimethyl-4-(4-oxiranylhexyloxy)phenyl)ethane,
1,2-bis(3,5-dimethyl-4-(4-oxiranylheptyloxy)phenyl)ethane,
1,2-bis(3,5-dimethyl-4-(4-oxiranyloctyloxy)phenyl)ethane,
1,2-bis(3,5-dimethyl-4-(4-oxiranylmethoxyethoxy)phenyl)ethane,
1,2-bis(3,5-diethyl-4-oxiranylmethoxyphenyl)ethane,
1,2-bis(3,5-diethyl-4-(2-methyloxiranylmethoxy)phenyl)ethane,
1,2-bis(3,5-diethyl-4-(3-methyloxiranylmethoxy)phenyl)ethane,
1,2-bis(3,5-diethyl-4-oxiranylmethoxyethoxyphenyl)ethane,
1,2-bis(3,5-diethyl-4-(2-oxiranylethoxy)phenyl)ethane,
1,2-bis(3,5-diethyl-4-(3-oxiranylpropoxy)phenyl)ethane,
1,2-bis(3,5-diethyl-4-(4-oxiranylbutoxy)phenyl)ethane,
1,2-bis(3,5-diethyl-4-(4-oxiranylpentyloxy)phenyl)ethane,
1,2-bis(3,5-diethyl-4-(4-oxiranylhexyloxy)phenyl)ethane,
1,2-bis(3,5-diethyl-4-(4-oxiranylheptyloxy)phenyl)ethane,
1,2-bis(3,5-diethyl-4-(4-oxiranyloctyloxy)phenyl)ethane,
1,2-bis(3,5-diethyl-4-(4-oxiranylmethoxyethoxy)phenyl)ethane,
1,2-bis(3,5-diisopropyl-4-(oxiranylmethoxy)phenyl)ethane,
1,2-bis(3,5-diisopropyl-4-(2-methyloxiranylmethoxy)phenyl)ethane,
1,2-bis(3,5-diisopropyl-4-(3-methyloxiranylmethoxy)phenyl)ethane,
1,2-bis(3,5-diisopropyl-4-oxiranylmethoxyethoxyphenyl)ethane,
1,2-bis(3,5-diisopropyl-4-(2-oxiranylethoxy)phenyl)ethane,
1,2-bis(3,5-diisopropyl-4-(3-oxiranylpropoxy)phenyl)ethane,
1,2-bis(3,5-diisopropyl-4-(4-oxiranylbutoxy)phenyl)ethane,
1,2-bis(3,5-diisopropyl-4-(4-oxiranylpentyloxy)phenyl)ethane,
1,2-bis(3,5-diisopropyl-4-(4-oxiranylhexyloxy)phenyl)ethane,
1,2-bis(3,5-diisopropyl-4-(4-oxiranylheptyloxy)phenyl)ethane,
1,2-bis(3,5-diisopropyl-4-(4-oxiranyloctyloxy)phenyl)ethane,
1,2-bis(3,5-diisopropyl-4-(4-oxiranylmethoxyethoxy)phenyl)ethane,
1,2-bis(3,5-di-tert-butyl-4-oxiranylmethoxyphenyl)ethane,
1,2-bis(3,5-di-tert-butyl-4-(2-methyloxiranylmethoxy)phenyl)ethane,
1,2-bis(3,5-di-tert-butyl-4-(3-methyloxiranylmethoxy)phenyl)ethane,
1,2-bis(3,5-di-tert-butyl-4-oxiranylmethoxyethoxyphenyl)ethane,
1,2-bis(3,5-di-tert-butyl-4-(2-oxiranylethoxy)phenyl)ethane,

1,2-bis(3,5-di-tert-butyl-4-(3-oxiranylpropoxy)phenyl) ethane,
1,2-bis(3,5-di-tert-butyl-4-(4-oxiranylbutoxy)phenyl)ethane,
1,2-bis(3,5-di-tert-butyl-4-(4-oxiranylpentyloxy)phenyl)ethane,
1,2-bis(3,5-di-tert-butyl-4-(4-oxiranylhexyloxy)phenyl)ethane,
1,2-bis(3,5-di-tert-butyl-4-(4-oxiranylheptyloxy)phenyl)ethane,
1,2-bis(3,5-di-tert-butyl-4-(4-oxiranyloctyloxy)phenyl)ethane,
1,2-bis(3,5-di-tert-butyl-4-(4-oxiranylmethoxyethoxy)phenyl)ethane,
1,2-bis(3,5-di-tert-pentyl-4-oxiranylmethoxyphenyl)ethane,
1,2-bis(3,5-di-tert-pentyl-4-(2-methyloxiranylmethoxy)phenyl)ethane,
1,2-bis(3,5-di-tert-pentyl-4-(3-methyloxiranylmethoxy)phenyl)ethane,
1,2-bis(3,5-di-tert-pentyl-4-oxiranylmethoxyethoxyphenyl)ethane,
1,2-bis(3,5-di-tert-pentyl-4-(2-oxiranylethoxy)phenyl)ethane,
1,2-bis(3,5-di-tert-pentyl-4-(3-oxiranylpropoxy)phenyl)ethane,
1,2-bis(3,5-di-tert-pentyl-4-(4-oxiranylbutoxy)phenyl)ethane,
1,2-bis(3,5-di-tert-pentyl-4-(4-oxiranylpentyloxy)phenyl)ethane,
1,2-bis(3,5-di-tert-pentyl-4-(4-oxiranylhexyloxy)phenyl)ethane,
1,2-bis(3,5-di-tert-pentyl-4-(4-oxiranylheptyloxy)phenyl)ethane,
1,2-bis(3,5-di-tert-pentyl-4-(4-oxiranyloctyloxy)phenyl)ethane,
1,2-bis(3,5-di-tert-pentyl-4-(4-oxiranylmethoxyethoxy)phenyl)ethane,
1,2-bis(3,5-di-tert-octyl-4-oxiranylmethoxyphenyl)ethane,
1,2-bis(3,5-di-tert-octyl-4-(2-methyloxiranylmethoxy)phenyl)ethane,
1,2-bis(3,5-di-tert-octyl-4-(3-methyloxiranylmethoxy)phenyl)ethane,
1,2-bis(3,5-di-tert-octyl-4-oxiranylmethoxyethoxyphenyl)ethane,
1,2-bis(3,5-di-tert-octyl-4-(2-oxiranylethoxy)phenyl)ethane,
1,2-bis(3,5-di-tert-octyl-4-(3-oxiranylpropoxy)phenyl)ethane,
1,2-bis(3,5-di-tert-octyl-4-(4-oxiranylbutoxy)phenyl)ethane,
1,2-bis(3,5-di-tert-octyl-4-(4-oxiranylpentyloxy)phenyl)ethane,
1,2-bis(3,5-di-tert-octyl-4-(4-oxiranylhexyloxy)phenyl)ethane,
1,2-bis(3,5-di-tert-octyl-4-(4-oxiranylheptyloxy)phenyl)ethane,
1,2-bis(3,5-di-tert-octyl-4-(4-oxiranyloctyloxy)phenyl)ethane,
1,2-bis(3,5-di-tert-octyl-4-(4-oxiranylmethoxyethoxy)phenyl)ethane,
2,2-bis(3,5-dimethyl-4-oxiranylmethoxyphenyl)propane,
2,2-bis(3,5-dimethyl-4-(2-methyloxiranylmethoxy)phenyl)propane,
2,2-bis(3,5-dimethyl-4-(3-methyloxiranylmethoxy)phenyl)propane,
2,2-bis(3,5-dimethyl-4-(oxiranylmethoxyethoxy)phenyl)propane,
2,2-bis(3,5-dimethyl-4-(2-oxiranylethoxy)phenyl)propane,
2,2-bis(3,5-dimethyl-4-(3-oxiranylpropoxy)phenyl)propane,
2,2-bis(3,5-dimethy-4-(4-oxiranylbutoxy)phenyl)propane,
2,2-bis(3,5-dimethyl-4-(4-oxiranylpentyloxy)phenyl)propane,
2,2-bis(3,5-dimethyl-4-(4-oxiranylhexyloxy)phenyl)propane,
2,2-bis(3,5-dimethyl-4-(4-oxiranylheptyloxy)phenyl)propane,
2,2-bis(3,5-dimethyl-4-(4-oxiranyloctyloxy)phenyl)propane,
2,2-bis(3,5-dimethyl-4-(4-oxiranylmethoxyethoxy)phenyl)propane,
2,2-bis(3,5-diethyl-4-oxiranylmethoxyphenyl)propane,
2,2-bis(3,5-diethyl-4-(2-methyloxiranylmethoxy)phenyl)propane,
2,2-bis(3,5-diethyl-4-(3-methyloxiranylmethoxy)phenyl)propane,
2,2-bis(3,5-diethyl-4-oxiranylmethoxyethoxyphenyl)propane,
2,2-bis(3,5-diethyl-4-(2-oxiranylethoxy)phenyl)propane,
2,2-bis(3,5-diethyl-4-(3-oxiranylpropoxy)phenyl)propane,
2,2-bis(3,5-diethyl-4-(4-oxiranylbutoxy)phenyl)propane,
2,2-bis(3,5-diethyl-4-(4-oxiranylpentyloxy)phenyl)propane,
2,2-bis(3,5-diethyl-4-(4-oxiranylhexyloxy)phenyl)propane,
2,2-bis(3,5-diethyl-4-(4-oxiranylheptyloxy)phenyl)propane,
2,2-bis(3,5-diethyl-4-(4-oxiranyloctyloxy)phenyl)propane,
2,2-bis(3,5-diethyl-4-(4-oxiranylmethoxyethoxy)phenyl)propane,
2,2-bis(3,5-diisopropyl-4-(oxiranylmethoxy)phenyl)propane,
2,2-bis((3,5-diisopropyl-4-(2-methyloxiranylmethoxy)phenyl)propane,
2,2-bis(3,5-diisopropyl-4-(3-methyloxiranylmethoxy)phenyl)propane,
2,2-bis(3,5-diisopropyl-4-oxiranylmethoxyethoxyphenyl)propane,
2,2-bis(3,5-diisopropyl-4-(2-oxiranylethoxy)phenyl)propane,
2,2-bis(3,5-diisopropyl-4-(3-oxiranylpropoxy)phenyl)propane,
2,2-bis(3,5-diisopropyl-4-(4-oxiranylbutoxy)phenyl)propane,
2,2-bis(3,5-diisopropyl-4-(4-oxiranylpentyloxy)phenyl)propane,
2,2-bis(3,5-diisopropyl-4-(4-oxiranylhexyloxy)phenyl)propane,
2,2-bis(3,5-diisopropyl-4-(4-oxiranylheptyloxy)phenyl)propane,
2,2-bis(3,5-diisopropyl-4-(4-oxiranyloctyloxy)phenyl)propane,
2,2-bis(3,5-diisopropyl-4-(4-oxiranylmethoxyethoxy)phenyl)propane,
2,2-bis(3,5-di-tert-butyl-4-oxiranylmethoxyphenyl)propane,
2,2-bis(3,5-di-tert-butyl-4-(2-methyloxiranylmethoxy)phenyl)propane,
2,2-bis(3,5-di-tert-butyl-4-(3-methyloxiranylmethoxy)phenyl)propane,
2,2-bis(3,5-di-tert-butyl-4-oxiranylmethoxyethoxyphenyl)propane,
2,2-bis(3,5-di-tert-butyl-4-(2-oxiranylethoxy)phenyl)propane,
2,2-bis(3,5-di-tert-butyl-4-(3-oxiranylpropoxy)phenyl)propane,
2,2-bis(3,5-di-tert-butyl-4-(4-oxiranylbutoxy)phenyl)propane,
2,2-bis(3,5-di-tert-butyl-4-(4-oxiranylpentyloxy)phenyl)propane,
2,2-bis(3,5-di-tert-butyl-4-(4-oxiranylhexyloxy)phenyl)propane,
2,2-bis(3,5-di-tert-butyl-4-(4-oxiranylheptyloxy)phenyl)propane,
2,2-bis(3,5-di-tert-butyl-4-(4-oxiranyloctyloxy)phenyl)propane,
2,2-bis(3,5-di-tert-butyl-4-(4-oxiranylmethoxyethoxy)phenyl)propane,
2,2-bis(3,5-di-tert-pentyl-4-oxiranylmethoxyphenyl)propane,
2,2-bis(3,5-di-tert-pentyl-4-(2-methyloxiranylmethoxy)phenyl)propane,
2,2-bis(3,5-di-tert-pentyl-4-(3-methyloxiranylmethoxy)phenyl)propane,
2,2-bis(3,5-di-tert-pentyl-4-oxiranylmethoxyethoxyphenyl)propane,
2,2-bis(3,5-di-tert-pentyl-4-(2-oxiranylethoxy)phenyl)propane,
2,2-bis(3,5-di-tert-pentyl-4-(3-oxiranylpropoxy)phenyl)propane,
2,2-bis(3,5-di-tert-pentyl-4-(4-oxiranylbutoxy)phenyl)propane,
2,2-bis(3,5-di-tert-pentyl-4-(4-oxiranylpentyloxy)phenyl)propane,
2,2-bis(3,5-di-tert-pentyl-4-(4-oxiranylhexyloxy)phenyl)propane,
2,2-bis(3,5-di-tert-pentyl-4-(4-oxiranylheptyloxy)phenyl)propane,
2,2-bis(3,5-di-tert-pentyl-4-(4-oxiranyloctyloxy)phenyl)propane,
2,2-bis(3,5-di-tert-pentyl-4-(4-oxiranylmethoxyethoxy)phenyl)propane,
2,2-bis(3,5-di-tert-octyl-4-oxiranylmethoxyphenyl)propane,
2,2-bis(3,5-di-tert-octyl-4-(2-methyloxiranylmethoxy)phenyl)propane,
2,2-bis(3,5-di-tert-octyl-4-(3-methyloxiranylmethoxy)phenyl)propane,
2,2-bis(3,5-di-tert-octyl-4-oxiranylmethoxyethoxyphenyl)propane,
2,2-bis(3,5-di-tert-octyl-4-(2-oxiranylethoxy)phenyl)propane,
2,2-bis(3,5-di-tert-octyl-4-(3-oxiranylpropoxy)phenyl)propane,
2,2-bis(3,5-di-tert-octyl-4-(4-oxiranylbutoxy)phenyl)propane,
2,2-bis(3,5-di-tert-octyl-4-(4-oxiranylpentyloxy)phenyl)propane,
2,2-bis(3,5-di-tert-octyl-4-(4-oxiranylhexyloxy)phenyl)propane,
2,2-bis(3,5-di-tert-octyl-4-(4-oxiranylheptyloxy)phenyl)propane,
2,2-bis(3,5-di-tert-octyl-4-(4-oxiranyloctyloxy) phenyl) propane, and
2,2-bis(3,5-di-tert-octyl-4-(4-oxiranylmethoxyethoxy)phenyl)propane.

Among these epoxy compounds,
4,4'-bis(oxiranylmethoxy)biphenyl,
4,4'-bis(2-methyloxiranylmethoxy)biphenyl,
4,4'-bis(3-methyloxiranylmethoxy)biphenyl,
4,4'-bis(oxiranylmethoxyethoxy)biphenyl,
4,4'-bis(2-oxiranylethoxy)biphenyl,
4,4'-bis(3-oxiranylpropoxy)biphenyl,
4,4'-bis(4-oxiranylbutoxy)biphenyl,
4,4'-bis(4-oxiranylpentyloxy)biphenyl,
4,4'-bis(4-oxiranylhexyloxy)biphenyl,
4,4'-bis(4-oxiranylheptyloxy)biphenyl,
4,4'-bis(4-oxiranyloctyloxy)biphenyl,
4,4'-bis(4-oxiranylmethoxyethoxy)biphenyl,
3,3',5,5'-tetramethyl-4,4'-bis(oxiranylmethoxy)biphenyl,
3,3',5,5'-tetramethyl-4,4'-bis(2-methyloxiranylmethoxy)biphenyl,
3,3',5,5'-tetramethyl-4,4'-bis(3-methyloxiranylmethoxy)biphenyl,
3,3',5,5'-tetramethyl-4,4'-bis(oxiranylmethoxyethoxy)biphenyl,
3,3,5,5'-tetrarmethyl-4,4'-bis(2-oxiranylethoxy)biphenyl,
3,3',5,5'-tetramethyl-4,4'-bis(3-oxiranylpropoxy)biphenyl,
3,3',5,5'-tetramethyl-4,4'-bis(4-oxiranylbutoxy)biphenyl,
3,3',5,5'-tetramethyl-4,4'-bis(4-oxiranylpentyloxy)biphenyl,
3,3',5,5'-tetramethyl-4,4'-bis(4-oxiranylhexyloxy)biphenyl,
3,3',5,5'-tetramethyl-4,4'-bis(4-oxiranylheptyloxy)biphenyl,
3,3',5,5'-tetramethyl-4,4'-bis(4-oxiranyloctyloxy)biphenyl,
3,3',5,5'-tetramethyl-4,4'-bis(4-oxiranylmethoxyethoxy)biphenyl,
3,3',5,5'-tetraethyl-4,4'-bis(oxiranylmethoxy)biphenyl,
3,3',5,5'-tetraethyl-4,4'-bis(2-methyloxiranylmethoxy)biphenyl,
3,3',5,5'-tetraethyl-4,4'-bis(3-methyloxiranylmethoxy)biphenyl,
3,3',5,5'-tetraethyl-4,4'-bis(oxiranylmethoxyethoxy)biphenyl,
3,3',5,5'-tetraethyl-4,4'-bis(2-oxiranylethoxy)biphenyl,
3,3',5,5'-tetraethyl-4,4'-bis(3-oxiranylpropoxy)biphenyl,
3,3',5,5'-tetraethyl-4,4'-bis(4-oxiranylbutoxy)biphenyl,
3,3',5,5'-tetraethyl-4,4'-bis(4-oxiranylpentyloxy)biphenyl,
3,3',5,5'-tetraethyl-4,4'-bis(4-oxiranylhexyloxy)biphenyl,
3,3',5,5'-tetraethyl-4,4'-bis(4-oxiranylheptyloxy)biphenyl,
3,3',5,5'-tetraethyl-4,4'-bis(4-oxiranyloctyloxy)biphenyl,
3,3',5,5'-tetraethyl-4,4'-bis(4-oxiranylmethoxyethoxy)biphenyl,
3,3',5,5'-tetra-isopropyl-4,4'-bis(oxiranylmethoxy)biphenyl,
3,3',5,5'-tetra-isopropyl-4,4'-bis(2-methyloxiranylmethoxy)biphenyl,
3,3',5,5'-tetra-isopropyl-4,4'-bis(3-methyloxiranylmethoxy)biphenyl,

3,3',5,5'-tetra-isopropyl-4,4'-bis(oxiranylmethoxyethoxy)biphenyl,
3,3',5,5'-tetra-isopropyl-4,4'-bis(2-oxiranylethoxy)biphenyl,
3,3',5,5'-tetra-zsopropyl-4,4'-bis(3-oxiranylpropoxy)biphenyl,
3,3',5,5'-tetra-isopropyl-4,4'-bis(4-oxiranylbutoxy)biphenyl,
3,3',5,5'-tetra-isopropyl-4,4'-bis(4-oxiranylpentyloxy)biphenyl,
3,3',5,5'-tetra-isopropyl-4,4'-bis(4-oxiranylhexyloxy)biphenyl,
3,3',5,5'-tetra-isopropyl-4,4'-bis(4-oxiranylheptyloxy)biphenyl,
3,3',5,5'-tetra-isopropyl-4,4'-bis(4-oxiranyloctyloxy)biphenyl,
3,3',5,5'-tetra-isopropyl-4,4'-bis(4-oxiranylmethoxyethoxy)biphenyl,
3,3',5,5'-tetra-tert-butyl-4,4'-bis(oxiranylmethoxy)biphenyl,
3,3',5,5'-tetra-tert-butyl-4,4'-bis(2-methyloxiranylmethoxy)biphenyl,
3,3',5,5'-tetra-tert-butyl-4,4'-bis(3-methyloxiranylmethoxy)biphenyl,
3,3',5,5'-tetra-tert-butyl-4,4'-bis(oxiranylmethoxyethoxy)biphenyl,
3,3',5,5'-tetra-tert-butyl-4,4'-bis(2-oxiranylethoxy)biphenyl,
3,3',5,5'-tetra-tert-butyl-4,4'-bis(3-oxiranylpropoxy)biphenyl,
3,3',5,5'-tetra-tert-butyl-4,4'-bis(4-oxiranylbutoxy)biphenyl,
3,3',5,5'-tetra-tert-butyl-4,4'-bis(4-oxiranylpentyloxy)biphenyl,
3,3',5,5'-tetra-tert-butyl-4,4'-bis(4-oxiranylhexyloxy)biphenyl,
3,3',5,5'-tetra-tert-butyl-4,4'-bis(4-oxiranylheptyloxy)biphenyl,
3,3',5,5-'-tetra-tert-butyl-4,4'-bis(4-oxiranyloctyloxy)biphenyl,
3,3',5,5'-tetra-tert-butyl-4,4'-bis(4-oxiranylmethoxyethoxy)biphenyl,
3,3',5,5'-tetra-tert-pentyl-4,4'-bis(oxiranylmethoxy)biphenyl,
3,3',5,5'-tetra-tert-pentyl-4,4'-bis(2-methyloxiranylmethoxy)biphenyl,
3,3',5,5'-tetra-tert-pentyl-4,4'-bis(3-methyloxiranylmethoxy)biphenyl,
3,3',5,5'-tetra-tert-pentyl-4,4'-bis(oxiranylmethoxyethoxy)biphenyl,
3,3',5,5'-tetra-tert-pentyl-4,4'-bis(2-oxiranylethoxy)biphenyl,
3,3',5,5'-tetra-tert-pentyl-4,4'-bis(3-oxiranylpropoxy)biphenyl,
3,3',5,5'-tetra-tert-pentyl-4,4'-bis(4-oxiranylbutoxy)biphenyl,
3,3',5,5'-tetra-tert-pentyl-4,4'bis(4-oxiranylpentyloxy)biphenyl,
3,3',5,5'-tetra-tert-pentyl-4,4'-bis(4-oxiranylhexyloxy)biphenyl,
3,3',5,5'-tetra-tert-pentyl-4,4'-bis(4-oxiranylheptyloxy)biphenyl,
3,3',5,5'-tetra-tert-pentyl-4,4'-bis(4-oxiranyloctyloxy)biphenyl,
3,3',5,5'-tetra-tert-pentyl-4,4'-bis(4-oxiranylmethoxyethoxy)biphenyl,
3,3',5,5'-tetra-tert-octyl-4,4'-bis(oxiranylmethoxy)biphenyl,
3,3',5,5'-tetra-tert-octyl-4,4'-bis(2-methyloxiranylmethoxy)biphenyl,
3,3',5,5'-tetra-tert-octyl-4,4'-bis(3-methyloxiranylmethoxy)biphenyl,
3,3',5,5'-tetra-tert-octyl-4,4'-bis(oxiranylmethoxyethoxy)biphenyl,
3,3',5,5'-tetra-tert-octyl-4,4'-bis(2-oxiranylethoxy)biphenyl,
3,3',5,5'-tetra-tert-octyl-4,4'-bis(3-oxiranylpropoxy)biphenyl,
3,3',5,5'-tetra-tert-octyl-4,4'-bis(4-oxiranylbutoxy)biphenyl,
3,3',5,5'-tetra-tert-octyl-4,4'-bis(4-oxiranylpentyloxy)biphenyl,
3,3',5,5'-tetra-tert-octyl-4,4'-bis(4-oxiranylhexyloxy)biphenyl,
3,3',5,5'-tetra-tert-octyl-4,4'-bis(4-oxiranylheptyloxy)biphenyl,
3,3',5,5'-tetra-tert-octyl-4,4'-bis(4-oxiranyloctyloxy)biphenyl and
3,3',5,5'-tetra-tert-octyl-4,4'-bis(4-oxiranylmethoxyethoxy)biphenyl are preferred.
   As the epoxy compound (2), commercially available epoxy compounds may be used and can be purchased, for example, from Japan Epoxy Resins Co., Ltd.

Subsequently, the resin composition of the present invention and a cured resin will be explained.
The resin composition of the present invention contains an epoxy compound (1) and an epoxy compound (2). The resin composition is obtained by mixing the epoxy compound (1) and the epoxy compound (2) directly or in a solvent. Examples of the solvent include ketone solvents such as methyl ethyl ketone and methyl isobutyl ketone, aprotic polar solvents such as dimethyl sulfoxide and N-methyl pyrrolidone, ester solvents such as butyl acetate, and glycol solvents such as propylene glycol monomethyl ether.

A weight ratio of the epoxy compound (1) to the epoxy compound (2) in the resin composition, (epoxy compound (1)/epoxy compound (2)), is usually from 98/2 to 50/50, and preferably from 90/10 to 70/30.
The resin composition may contain two or more different kinds of epoxy compounds (2).

The resin composition may further contain a curing agent.
The curing agent may have at least two functional groups capable of causing a curing reaction with an epoxy group in the molecule and examples thereof include an amine type curing agent having amino groups as functional groups, a phenol type curing agent having hydroxyl groups as functional groups, and an acid anhydride type curing agent having carboxyl groups as functional groups. Among these curing agents, an amine type curing agent or a phenol type curing agent is preferred.

Examples of the amine type curing agent include aliphatic polyvalent amines having 2 to 20 carbon atoms such as ethylenediamine, trimethylenediamine, tetramethylenediamine, hexamethylenediamine, diethylenetriamine and triethylenetetramine; aromatic polyvalent amines such as p-xylenediamine, m-xylenediamine, 1,5-diaminonaphthalene, m-phenylenediamine, p-phenylenediamine, 4,4'-diaminodiphenylmethane, 4,4'-diaminodiphenylethane, 4,4'-diaminodiphenylpropane, 4,4'-diaminodiphenylether, 1,1-bis(4-aminophenyl)cyclohexane, 4,4'-diaminodiphenylsulfone and bis(4-aminophenyl)phenylmethane; alicyclic polyvalent amines such as 4,4'-diaminodicyclohexane and 1,3-bis(aminomethyl)cyclohexane; and dicyandiamide. Among these amine type curing agents, aromatic polyvalent amines are preferred, and 4,4'-diaminodiphenylmethane, 4,4'-diaminodiphenylethane, 1,5-diaminonaphthalene and p-phenylenediamine are more preferred.

Examples of the phenol type curing agent include phenol resin, phenol aralkyl resin (having a phenylene framework, diphenylene framework, etc.), naphthol aralkyl resin and polyoxystyrene resin. Examples of the phenol resin include resol type phenol resins such as aniline-modified resol resin and dimethyl ether resol resin; novolak type phenol resins such as phenol novolak resin, cresol novolak resin, tert-butyl phenol novolak resin and nonyl phenol novolak resin; special phenol resins such as dicyclopentadiene-modified phenol resin, terpene-modified phenol resin and triphenol methane type resin. Examples of the poloxystyrene resin include poly(p-oxystyrene).

Examples of the acid anhydride type curing agent include maleic anhydride, phthalic anhydride, pyromellitic anhydride and trimellitic anhydride.

The curing agent is used in such an amount that the total amount of functional groups capable of causing a curing reaction with an epoxy group is usually 0.5 to 1.5 equivalent times, and preferably from 0.9 to 1.1 equivalent times based on the total amount of epoxy groups in the epoxy compound (1) and the epoxy compound (2) in the resin composition.

The resin composition may further contain said solvents, another epoxy compounds and various additives. Examples of the additive include silica powders such as fused crushed silica powder, fused spherical silica powder, crystal silica powder and secondary aggregated silica powder; fillers such as alumina, aluminum nitride, boron nitride, silicon nitride, silicon carbide, titanium white, aluminum hydroxide, magnesia, talc, clay, mica and glass fiber; metals such as copper, aluminum and iron; curing accelerators such as triphenylphosphine, l,8-azabicyclo[5.4.0]-7-undecene and 2-methylimidazole; coupling agents such as γ-glycidoxypropyltrimethoxysilane; colorants such as carbon black; low-stress components such as silicone oil and silicone rubber; mold release agents such as natural wax, synthetic wax, higher fatty acid or metal salt thereof, and paraffin; and antioxidants. Among these additives, fillers are preferred. The content of another epoxy compounds and additives may be the content which does not adversely affect desired performances of the cured resin obtained by curing the resin composition of the present invention.

The cured resin can be obtained by curing a resin composition containing a curing agent.
The curing temperature is usually from 120°C to 200°C.
Examples of the method of producing the cured resin include a method of curing a resin composition by heating to a predetermined temperature; a method of melting a resin composition with heating, injecting the melt into a mold and heating the mold, followed by molding; a method of melting a resin composition, injecting the resultant melt in a preheated mold and curing the melt; a method of filling a mold with a powder, which is obtained by partially curing a resin composition and grinding the resultant partially cured resin composition, and melt-molding the filled powder; and a method of optionally dissolving a resin composition in a solvent, partially curing with stirring, casting the resultant solution, removing the solvent through draft drying etc and optionally heating for a predetermined time while applying a pressure using a press etc.

Also, a prepreg can be produced by optionally diluting a resin composition containing a curing agent with a solvent, applying or impregnating a base material with the resin composition and semi-curing the epoxy compound in the base material through heating the applied or impregnated base material. Examples of the base material include woven or nonwoven fabric made of an inorganic fiber, such as glass fiber woven fabric; and woven or nonwoven fabric made of an organic fiber such as polyester fiber. Using the prepreg, a laminate can be easily produced by a conventional method.

### Examples

Hereinafter, the present invention is further illustrated in detail by referring to Examples, but the present invention is not limited to Examples.

### Example 1

1-{2-methyl-4-(oxiranylmethoxy)phenyl}-4-{4-(oxiranylmethoxy)phenyl}-1-cyclohexene (compound A) as an epoxy compound (1) and 4,4'-bis(oxiranylmethoxy)biphenyl (compound B) as an epoxy compound (2) were mixed to prepare a resin composition (composition X). To the resultant composition X, 4,4'-diaminodiphenylmethane (DDM) as a curing agent, an alumina powder as a filler and methyl ethyl ketone as a solvent were added to prepare a resin composition (composition Y). A ratio of a compound A to a compound B in the composition Y was 80:20 in terms of an epoxy equivalent ratio, and 84:16 in terms of a weight ratio. Also, a ratio of the total of the compound A and the compound B to the curing agent was 1:1 in terms of an equivalent ratio (epoxy group/amino group). Also, the filler was blended so that a volume ratio of the filler to a cured resin obtained by curing the composition Y was 70%. The composition Y was applied on a 0.018 mm thick copper foil, one surface (top surface) of which was roughed, as a base material in a predetermined thickness by casting and then dried by heating to obtain a prepreg. The prepreg was placed so that the resin-applied surface faced upward, and a 0.2 mm thick copper foil, one surface (bottom surface) of which was roughed, was laid thereon, and then the prepreg was cured by vacuum heat press at 130°C, thus bonding the prepreg and the copper foil. As a result of complete curing by heating at a temperature of 205°C for 2 hours, a sheet-like cured resin was obtained. Test pieces were cut out from the resultant cured resin and the copper foils existing on both surfaces were removed by acid etching, and then only a sheet-like resin layer was taken out. Using an apparatus by a Flash method (Xe Flash Analyzer, Model LFA447 manufactured by NETZSCH Instruments, Inc. in conformity with ASTM E1461), a thermal diffusion factor of the resin layer was measured and then a thermal conductivity in a thickness direction was determined by multiplication of the resultant thermal diffusion factor by a density measured by an Archimedes's method and a specific heat measured by a DSC method. With respect to another test piece, an epoxy adhesive was uniformly applied on the surface of a 0.2 mm thick copper foil and a 2 mm thick copper plate having the same size as a reinforcing plate was laminated thereon, and then a peeling strength of the 0.018 mm copper foil existing on the opposite surface was measured in conformity with JIS C 6481.

### Example 2

In the same manner as in Example 1, except that vacuum heat press was performed at 145°C, a sheet-like cured resin was obtained. Test pieces were cut out from the resultant cured resin, and then a thermal conductivity and a copper foil peeling strength were measured in the same manner as in Example 1.

### Comparative Example 1

In the same manner as in Example 1, except that only the compound A was used in place of the compound A and the compound B in Example 1, a sheet-like cured resin was obtained. Test pieces were cut out from the resultant cured resin, and then a thermal conductivity and a copper foil peeling strength were measured in the same manner as in Example 1.

### Comparative Example 2

In the same manner as in Example 2, except that only the compound A was used in place of the compound A and the compound B in Example 2, a sheet-like cured resin was obtained. Test pieces were cut out from the resultant cured resin, and then a thermal conductivity and a copper foil peeling strength were measured in the same manner as in Example 1.
The evaluation results of Examples 1 and 2 as well as Comparative Examples 1 and 2 are summarized in Table 1.

**Table 1**

| | | Example 1 | Example 2 | Comparative Example 1 | Comparative Example 2 |
|---|---|---|---|---|---|
| Epoxy compound (weight ratio) | Compound A | 84 | 84 | 100 | 100 |
| | Compound B | 16 | 16 | 0 | 0 |
| Curing agent | | DDM | DDM | DDM | DDM |
| Vacuum press temperature (°C) | | 130 | 145 | 130 | 145 |
| Thermal conductivity (W/mK) | | 7.1 | 7.5 | 5.0 | 7.2 |
| Copper foil peeling strength (kN/m) | | 1.5 | 1.5 | 0.9 | 1.5 |

When Comparative Example 1 is compared with Comparative Example 2, it is apparent that the thermal conductivity and the copper foil peeling strength of the cured resin of Comparative Example 1, in which the vacuum press temperature was low, were lower than those of the cured resin of Comparative Example 2. It is considered that, in Comparative Example 1, the curing temperature (vacuum press temperature) was not within a curing temperature range where a cured resin showing liquid crystallinity could be obtained from a resin composition containing only a compound A, and a sufficient conformation was not formed upon curing, and thus the thermal conductivity became lower. In contrast, in Comparative Example 2, it is considered that the curing temperature was within a curing temperature range where a cured resin showing liquid crystallinity could be obtained, and thus the thermal conductivity was higher than that of Comparative Example 1. Also, it is considered that since the low curing temperature caused poor flow of the resin upon pressing and decreased an adhesion force at an interface between the resin layer and the copper foil, the copper foil peeling strength of the cured resin of Comparative Example 1 became lower.

In contrast, the cured resin obtained in Example 1 had a high thermal conductivity even at the same curing temperature as that in Comparative Example 1. It is considered that blending of a compound B widened a curing temperature range where a cured resin showing liquid crystallinity could be obtained, and thus a sufficient conformation was formed. It is apparent that the copper foil peeling strength in Example 1 was the same level as that in Comparative Example 2 and Example 2, and also flow of the resin upon pressing was improved. Aiso, in Example 2, the thermal conductivity was higher than that in Comparative Example 2 under the same curing temperature conditions. It is considered that it became easier to form a conformation by blending of a compound B even within a curing temperature range where a cured resin showing liquid crystallinity could be obtained.

### Industrial Applicability

The resin composition of the present invention exhibits a wide range of a curing temperature at which a cured resin showing liquid crystallinity can be obtained, and enables easy production of a cured resin, and also the resultant cured resin shows liquid crystallinity and also has a high thermal conductivity, and is therefore useful as insulating materials of printed circuit boards etc to which high heat dissipation properties are required.

## Claims

1. A resin composition comprising an epoxy compound denoted by the formula (1): 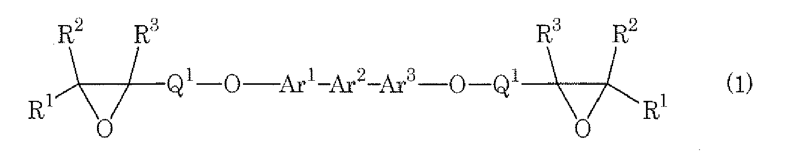 wherein Ar¹, Ar² and Ar³ are the same or different and each denotes any one of divalent groups denoted by the following formulas: 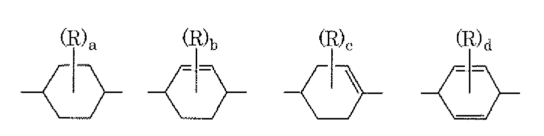 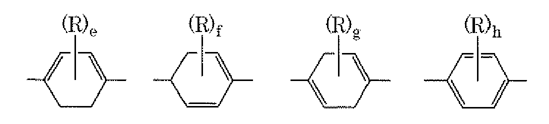 wherein R denotes a hydrogen atom or an alkyl group having 1 to 8 carbon atoms, a denotes an integer of 1 to 8, b, e and g denote an integer of 1 to 6, c denotes an integer of 1 to 7, d and h denote an integer of 1 to 4, f denotes an integer of 1 to 5, and when a to h denote an integer of 2 or more, all of R may be the same group or different groups; R¹, R² and R³ are the same or different and each denotes a hydrogen atom or an alkyl group having 1 to 8 carbon atoms; Q¹ denotes a straight-chain alkylene group having 1 to 8 carbon atoms,
wherein methylene groups composing said straight-chain alkylene group are optionally substituted with an alkyl group having 1 to 8 carbon atoms and -0- or -N(R⁴) - is optionally inserted between the methylene groups, wherein R⁴ denotes a hydrogen atom or an alkyl group having 1 to 8 carbon atoms, and an epoxy compound denoted by the formula (2): 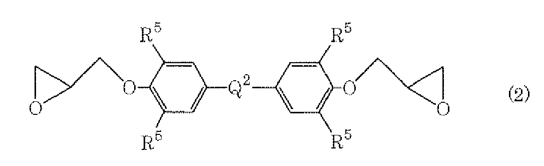 wherein R⁵ denotes a hydrogen atom or an alkyl group having 1 to 8 carbon atoms, Q² denotes a single bond or a straight-chain alkylene group having 1 to 8 carbon atoms, wherein methylene groups composing said straight-chain alkylene group are optionally substituted with an alkyl group having 1 to 8 carbon atoms.

2. The resin composition according to claim 1, wherein a weight ratio of the epoxy compound denoted by the formula (1) to the epoxy compound denoted by the formula (2), (epoxy compound denoted by the formula (1)/epoxy compound denoted by the formula (2)), is from 98/2 to 50/50.

3. The resin composition according to claim 1, wherein the epoxy compound denoted by the formula (1) is an epoxy compound denoted by the formula (3): 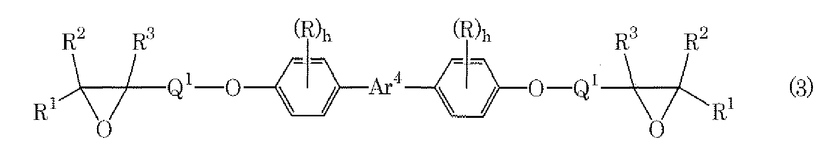 wherein Ar⁴ denotes any one of divalent groups denoted by the following formulas: 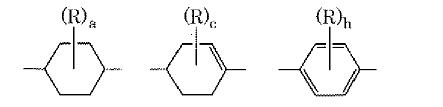 wherein R, R¹, R², R³, a, c and h are the same as defined above, Q¹ denotes any one of groups denoted by the following formulas: 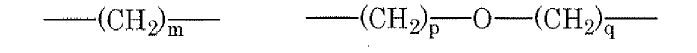 wherein m denotes an integer of 1 to 8, p and q denote an integer of 1 to 7 and the sum of p and q is 8 or less,
wherein methylene groups composing a group denoted by Q¹ are optionally substituted with an alkyl group having 1 to 8 carbon atoms.

4. The resin composition according to claim 3, wherein R¹, R² and R³ are hydrogen atoms.

5. The resin composition according to any one of claims 1 to 4, further containing a curing agent.

6. The resin composition according to claim 5, further containing a filler.

7. A cured resin obtained by curing the resin composition according to claim 5.

8. The cured resin according to claim 7, wherein the curing temperature is from 120°C to 200°C.

9. A cured resin obtained by curing the resin composition according to claim 6.

10. The cured resin according to claim 9, wherein the curing temperature is from 120°C to 200°C.

11. A prepreg obtained by applying or impregnating a base material with the resin composition according to any one of claims 1 to 4 and semi-curing the applied or impregnated base material.
